(19) Europäisches Patentamt
European Patent Office
Office européen des brevets

(11) **EP 4 224 477 B1**

(12) **FASCICULE DE BREVET EUROPEEN**

(45) Date de publication et mention
de la délivrance du brevet:
**21.01.2026 Bulletin 2026/04**

(21) Numéro de dépôt: **23154245.7**

(22) Date de dépôt: **31.01.2023**

(51) Classification Internationale des Brevets (IPC):
**G11C 13/00** *(2006.01)* **H03K 19/20** *(2006.01)*

(52) Classification Coopérative des Brevets (CPC):
**G11C 13/0026;** G06F 15/7821; G11C 2213/71;
G11C 2213/79; G11C 2213/82

(54) **STRUCTURE TRIDIMENSIONNELLE DE MÉMOIRES POUR LE CALCUL DANS LA MÉMOIRE**

DREIDIMENSIONALE SPEICHERSTRUKTUR ZUR SPEICHERBERECHNUNG

THREE-DIMENSIONAL MEMORY STRUCTURE FOR IN-MEMORY COMPUTING

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **03.02.2022 FR 2200963**

(43) Date de publication de la demande:
**09.08.2023 Bulletin 2023/32**

(73) Titulaire: **Commissariat à l'Energie Atomique et
aux Energies
Alternatives
75015 Paris (FR)**

(72) Inventeurs:
• **DUBREUIL, Théophile
38054 Grenoble Cedex 09 (FR)**
• **AMARI, Paul
38054 Grenoble Cedex 09 (FR)**

• **BARRAUD, Sylvain
38054 Grenoble Cedex 09 (FR)**

(74) Mandataire: **Atout PI Laplace
Immeuble Up On
25 Boulevard Romain Rolland
CS 40072
75685 Paris Cedex 14 (FR)**

(56) Documents cités:
**CN-B- 106 297 876    US-A1- 2020 335 165**

• **DUBREUIL TH�OPHILE: "Innovative 3D
Technology of a nonvolatile memory cell for In-
Memory-Computing", 31 December 2020
(2020-12-31), pages 1 - 50, XP055954765,
Retrieved from the Internet <URL:https://
webthesis.biblio.polito.it/16025/1/tesi.pdf>
[retrieved on 20220825]**

## Description

### Champ d'application

La présente invention concerne le domaine de la conception de circuits de mémoire calculatoire ou circuit de calcul dans la mémoire (traduite du terme anglais In-Memory Computing). Plus particulièrement, l'invention concerne un circuit de mémoires résistives non-volatiles. Le circuit permet de réaliser des opérations logiques booléennes élémentaires au sein de la structure des mémoires composant le circuit.

### Problème technique

D'une manière générale, un système sur puce comporte des circuits mémoires pour stocker les données et des circuits de calcul pour réaliser des opérations logiques et arithmétiques. Les opérations d'échange de données entre les circuits mémoires et les circuits de calcul sont très énergivores et réduisent la performance de calcul du système. Dans ce contexte, les technologies émergentes des mémoires non-volatiles permettent de réaliser des circuits de mémoire aptes à réaliser à la fois la fonction de stockage et la fonction de calcul. On parle dans ce cas de « circuit de calcul dans la mémoire ». Cela permet d'éviter les transferts de données entre les moyens de stockage et les moyens de calcul, et ainsi, permet de réduire la consommation énergétique et améliorer la vitesse de calcul.

Cependant, le développement des solutions « circuits de calcul dans la mémoire » présente plusieurs défis et contraintes tels que :

- Le recours à de larges circuits périphériques aux mémoires pour traiter les résultats. Ces circuits périphériques couvrent à titre d'exemple une pluralité d'amplificateurs de détection. Cela augmente considérablement la surface du circuit et la complexité d'implémentation physique,

- Des contraintes au niveau de la précision des calculs réalisés. Plus particulièrement, ce problème se manifeste lors de l'exécution d'algorithmes nécessitant des calculs en parallèle.

Ainsi, il existe un besoin pour concevoir des nouvelles architectures des circuits de calcul dans la mémoire, qui soient moins complexes et présentant en même temps une réduction de la consommation électrique et une amélioration des performances calculatoires en termes de vitesse et précision.

### Art antérieur/ Restrictions de l'état de l'art

La publication scientifique [1] décrit trois approches générales pour réaliser des opérations de « calcul en mémoire ». Les trois approches reposent sur la programmation d'opérandes au sein des cellules mémoires résistives qui permettent en retour d'effectuer des sommes et des produits grâce aux lois de Kirchhoff. La première solution est appelée « non-stateful logic » et la deuxième solution est appelée « matrix-vector-multiplication ». Ces deux solutions nécessitent l'utilisation de larges circuits périphériques aux mémoires afin de traiter les résultats bruts. Elles présentent ainsi les inconvénients associés aux circuits périphériques. Ces inconvénients consistent en une complexité d'implémentation, d'une large surface et d'une augmentation de la consommation énergétique. La troisième solution est appelée « stateful logic ». Cette solution ne nécessite pas de circuits périphériques larges. Cependant, elle présente l'inconvénient d'une réduction de la précision de calcul lors de l'exécution d'algorithmes nécessitant des opérations de calculs en parallèle.

La publication scientifique [2] propose une structure élémentaire de calcul en mémoire résistive réalisée par l'empilement d'une pluralité de mémoires résistives commandées par un transistor FinFET commun. Cette solution présente l'inconvénient d'une limitation en nombre de mémoires empilées dans une structure élémentaire à cause de l'augmentation des courants de pertes. De plus, cette solution présente des contraintes de programmation car les opérandes et les résultats d'une opération logique doivent être stockés au sein de la même structure élémentaire. Cela réduit les possibilités de programmation du circuit de calcul dans la mémoire et réduit ainsi la performance calculatoire du système.

La publication scientifique [3] montre un exemple de circuit de calcul dans une mémoire comprenant une pluralité de plans mémoire, chacun formant une matrice bidimensionnelle.

### Réponse au problème et apport solution

Pour pallier les limitations des solutions existantes en ce qui concerne la conception de circuits de calcul dans la mémoire, l'invention propose un circuit basé sur une structure tridimensionnelle composée de cellules mémoires résistives, non-volatiles et programmables. De plus, l'invention propose des séquences de programmation spécifiques permettant de réaliser des fonctions logiques élémentaires et des fonctions de transfert de données de manière non destructive. Il est ainsi possible pour la personne du métier d'implémenter des algorithmes plus complexes à partir des fonctions logiques élémentaires et de la fonction de transfert de données.

Le dispositif selon l'invention permet de réduire la complexité des circuits périphériques en se limitant à quelques transistors de commandes. Les opérations de calcul ne nécessitent pas de faire recours à des circuits du type amplificateur de détection. Cela réduit la surface du circuit et sa consommation énergétique et simplifie son implémentation physique.

Le dispositif selon l'invention permet en outre l'obtention d'un fonctionnement sur les trois dimensions spatiales sans les contraintes d'emplacement de stockage des opérandes et des résultats. Cela offre une flexibilité de programmation plus large que les solutions où les calculs sont localisés dans une seule structure élémentaire.

Le dispositif selon l'invention est réalisable avec un nombre de cellules mémoires considérablement supérieur à celui des solutions connues. Cela offre l'avantage de la multiplication des capacités de stockage et de calcul en même temps. Cela permet d'obtenir un dispositif compatible avec l'exécution d'algorithmes de calcul complexes au sein de la structure mémoires. De plus, le dispositif est capable de paralléliser un nombre considérable d'opérations de traitement de données pour obtenir une performance meilleure.

L'invention concerne en outre une structure en couches minces permettant de réaliser la structure de mémoire tridimensionnelle selon l'invention. Cette structure élémentaire présente l'avantage d'une compatibilité avec les techniques de fabrication de l'industrie du semiconducteur. Ainsi, le dispositif selon l'invention présente des couts de mise en production réduits.

### Résumé /Revendications

L'invention a pour objet un circuit de calcul dans la mémoire comprenant une pluralité de plans mémoire de rang i allant de 1 à N, avec N un entier naturel supérieur à 1, chaque plan formant une matrice bidimensionnelle de cellules mémoire non volatiles, résistives et programmables, chaque cellule mémoire ayant un nœud de sélection, un premier nœud d'entrée/sortie et un second nœud d'entrée/sortie. Ladite matrice comprenant M lignes de rang j allant de 1 à M et K colonnes de rang k allant de 1 à K, avec M et K deux entiers naturels non nuls. Ledit circuit de calcul comprenant :

- des moyens de contrôle configurés pour commander les noeuds des cellules mémoire pour réaliser des opérations de stockage et de calcul en mémoire réalisées par le circuit de calcul. Les moyens de contrôle sont configurés pour appliquer une séquence prédéterminée de tensions électriques sur les noeuds des cellules mémoire dudit groupe élémentaire de manière à obtenir un diviseur de tension pour réaliser la première opération logique,
- au moins un groupe élémentaire de cellules mémoires comprenant :

    ◦ une première cellule mémoire appartenant à l'un quelconque des plans mémoire et destinée à stocker une première donnée d'entrée ;
    ◦ une deuxième cellule mémoire appartenant à l'un quelconque des plans mémoire et destinée à stocker une deuxième donnée d'entrée ;
    ◦ une troisième cellule mémoire appartenant à un plan mémoire différent de celui de la première et de la deuxième cellule mémoire. La troisième cellule mémoire étant destinée à stocker le résultat d'une première opération logique ayant pour opérandes la première et la deuxième donnée d'entrée.

La première, la deuxième et la troisième cellule mémoire appartenant à des colonnes de même rang k dans leurs matrices respectives. La première, la deuxième et la troisième cellule mémoire étant interconnectées par une ligne d'interconnexion commune, notamment afin de former un pont diviseur de tension résistif. Ladite ligne d'interconnexion commune connectant l'un à l'autre les premiers nœuds d'entrée/sortie des cellules mémoire dudit groupe élémentaire ou les seconds nœuds d'entrée/sortie des cellules mémoire dudit groupe élémentaire.

Pour chaque plan mémoire:

- les nœuds de sélection des cellules mémoires appartenant à la même ligne sont interconnectés par une ligne de sélection ;
- les premiers nœuds d'entrée/sorties des cellules mémoires appartenant à la même colonne sont interconnectés ;
- les seconds nœuds d'entrée/sorties des cellules mémoires appartenant à la même colonne sont interconnectés.

Selon un aspect particulier de l'invention, chaque cellule mémoire comprend :

- une structure de stockage résistive programmable ayant :

- une électrode supérieure connectée au second nœud d'entrée/sortie de ladite cellule mémoire ;

- et une électrode inférieure ;

- un transistor de sélection ayant une grille connectée au nœud de sélection de ladite cellule mémoire et reliant l'électrode inférieure au premier nœud d'entrée/sortie de ladite cellule mémoire.

Selon un aspect particulier de l'invention, chaque colonne de cellules mémoire comprend :

- Un empilement d'une pluralité de transistors de sélection selon une première direction ;

    chaque transistor de sélection, notamment de type grille enrobante, comprenant un canal de conduction, perpendiculaire à la première direction en un matériau semiconducteur et ayant deux extrémités ;

    la première extrémité du canal correspondant à la source du transistor de sélection et la seconde correspondant au drain du transistor ;

- un premier pilier métallique selon la première direction connectant les sources des différents transistors de sélection ;

- une couche en diélectrique parallèle à la première direction et couvrant latéralement les drains des transistors de sélection ;

- au moins une couche métallique en parallèle à la première direction déposée sur la couche en diélectrique ;

- un second pilier métallique selon la première direction ayant un contact latéral avec l'au moins couche métallique ;

Pour chaque transistor de sélection, l'ensemble formé par le drain, la couche en diélectrique et la couche métallique constitue une structure de stockage résistive.

Selon un aspect particulier de l'invention, pour chaque plan mémoire :

    les premiers nœuds d'entrée/sortie des cellules mémoire appartenant aux colonnes de rangs impairs sont interconnectés formant une première ligne de source ;
    les premiers nœuds d'entrée des cellules mémoire appartenant aux colonnes de rangs pairs sont interconnectés formant une seconde ligne de source ;
    la première ligne de source et la seconde ligne de source étant distinctes.

Selon un aspect particulier de l'invention, le groupe élémentaire de cellules mémoires comprend en outre une quatrième cellule mémoire appartenant à un plan mémoire différent de celui de la première, deuxième et troisième cellule mémoire. La quatrième cellule mémoire étant destinée à stocker le résultat d'une deuxième opération logique ayant pour opérandes la première et la deuxième donnée d'entrée et utilisant le résultat de la première opération logique stocké dans la troisième cellule mémoire. La quatrième cellule mémoire étant connectée à la première, à la deuxième et à la troisième cellule mémoire via la ligne d'interconnexion commune.

Selon un aspect particulier de l'invention, pour chaque groupe élémentaire de cellules mémoires, la ligne d'interconnexion connecte l'un à l'autre les seconds nœuds d'entrée/sortie des cellules mémoire dudit groupe élémentaire.

Selon un aspect particulier de l'invention, les moyens de contrôle sont configurés pour réaliser les étapes suivantes, dans l'ordre d'énumération, afin de réaliser la fonction logique OU :

    i- Initialiser la troisième cellule à un état résistif haut ;
    ii- sélectionner la première et la troisième cellule mémoire en mettant à l'état passant leurs transistors de sélection ;
    iii- appliquer une première tension de lecture positive sur le premier nœud d'entrée/sortie de la première cellule mémoire et connecter simultanément le premier nœud d'entrée/sortie de la troisième cellule mémoire à la masse électrique ;
    iv- sélectionner la deuxième et la troisième cellule mémoire en mettant à l'état passant leurs transistors de sélection ;
    v- appliquer la première tension de lecture positive sur le premier nœud d'entrée/sortie de la première cellule mémoire et connecter simultanément le premier nœud d'entrée/sortie de la troisième cellule mémoire à la masse électrique ;

Chaque cellule mémoire présentant: un premier seuil de tension pour passer d'un état résistif haut à un état résistif bas ; et un second seuil de tension pour passer d'un état résistif bas à un état résistif haut supérieur au premier seuil de tension. Ladite première tension de lecture étant positive avec une amplitude supérieure ou égale au premier seuil de passage et strictement inférieure au second seuil de passage.

Selon un aspect particulier de l'invention, les moyens de contrôle sont configurés pour réaliser les étapes suivantes, dans l'ordre d'énumération, afin de réaliser la fonction logique NON-OU exclusive :

vi- Initialiser la quatrième cellule à un état résistif bas ;
vii- sélectionner la première, la troisième et la quatrième cellule mémoire en mettant à l'état passant leurs transistors ;
viii- réaliser simultanément :

a- l'application d'une deuxième tension de lecture positive sur le premier nœud d'entrée/sortie de la première cellule mémoire ;
b- l'application d'une troisième tension de lecture négative sur le premier nœud d'entrée/sortie de la troisième cellule mémoire ;
c- et l'application d'une quatrième tension de lecture positive sur le premier nœud d'entrée/sortie de la quatrième cellule mémoire ;

ix- sélectionner la deuxième, la troisième et la quatrième cellule mémoire en mettant à l'état passant leurs transistors de sélection ;
x- réaliser simultanément :

a- l'application de la deuxième tension de lecture positive sur le premier nœud d'entrée/sortie de la deuxième cellule mémoire ;
b- l'application de la troisième tension de lecture négative sur le premier nœud d'entrée/sortie de la troisième cellule mémoire ;
c- et l'application d'une quatrième tension de lecture positive sur le premier nœud d'entrée/sortie de la quatrième cellule mémoire ;

La valeur absolue de la troisième tension de lecture étant sensiblement égale à la valeur absolue de la deuxième tension de lecture. La somme de la valeur absolue de la quatrième tension de lecture et de la deuxième tension de lecture étant supérieure au second seuil de passage.

Selon un aspect particulier de l'invention, les moyens de contrôle sont configurés pour réaliser les étapes suivantes afin de réaliser la fonction logique ET :

i- Initialiser la troisième cellule à un état résistif haut ;
ii- sélectionner la première et la troisième cellule mémoire en mettant à l'état passant leurs transistors de sélection ;
iii- appliquer une première tension de lecture positive sur le premier nœud d'entrée/sortie de la première cellule mémoire et appliquer une deuxième tension de lecture positive sur le troisième nœud d'entrée/sortie de la troisième cellule mémoire ;
iv- sélectionner la deuxième et la troisième cellule mémoire en mettant à l'état passant leurs transistors de sélection ;
v- appliquer la première tension de lecture positive sur le premier nœud d'entrée/sortie de la première cellule mémoire et appliquer la deuxième tension de lecture positive sur le troisième nœud d'entrée/sortie de la troisième cellule mémoire ;

chaque cellule mémoire présentant:

un premier seuil de tension pour passer d'un état résistif haut à un état résistif bas ; et un second seuil de tension pour passer d'un état résistif bas à un état résistif haut supérieur au premier seuil de tension ;
ladite première tension de lecture ayant une amplitude strictement inférieure au second seuil de tension ; ladite seconde tension de lecture ayant une amplitude strictement supérieure au second seuil de tension.

Selon un aspect particulier de l'invention, le circuit de calcul dans la mémoire comprend en outre pour chaque ligne d'interconnexion_un transistor de régulation; chaque transistor de régulation ayant une grille recevant un signal de régulation et reliant la ligne d'interconnexion associée à la masse électrique ou à une tension d'alimentation du circuit de calcul, de manière à réaliser une impédance variable.

Selon un aspect particulier de l'invention, le circuit de calcul dans la mémoire comprend une pluralité de groupes élémentaires de cellules mémoires. Chaque ligne d'interconnexion étant connectée à une ligne d'interconnexion adjacente par l'intermédiaire d'un interrupteur.

Selon un aspect particulier de l'invention, les moyens de contrôle sont configurés pour réaliser le transfert d'une donnée stockée d'une cellule mémoire de départ à une cellule mémoire d'arrivée appartenant à un plan différent de celui de la cellule mémoire de départ et connectée à une ligne d'interconnexion adjacente à celle de la cellule mémoire de départ. Le transfert est réalisé en exécutant, dans l'ordre d'énumération, les étapes suivantes :

i'- initialiser la cellule d'arrivée à un état résistif haut ;
ii'- mettre l'interrupteur à l'état passant
iii'- réaliser simultanément :

   a. l'application d'une première tension de transfert positive sur le premier nœud d'entrée/sortie de la cellule mémoire de départ ;

   b. la connexion du premier nœud d'entrée/sortie de la cellule mémoire d'arrivée à la masse électrique ;

   c. l'application d'une seconde tension de transfert positive sur le premier nœud d'entrée/sortie de la cellule mémoire appartenant au même plan de la cellule mémoire de départ et connectée à la même ligne d'interconnexion de la cellule mémoire d'arrivée ;

   d. l'application de la seconde tension de transfert positive sur le premier nœud d'entrée/sortie de la cellule mémoire appartenant au même plan de la cellule mémoire d'arrivée et connectée à la même ligne de données (ou ligne de bits) de la cellule mémoire de départ ;

L'amplitude de la seconde tension de transfert étant inférieure ou égale à la moitié de la première tension de transfert.
Selon un aspect particulier de l'invention, pour chaque groupe élémentaire de cellules mémoires, la ligne d'interconnexion connecte l'un à l'autre les premiers nœuds d'entrée/sortie des cellules mémoire dudit groupe élémentaire.
On entend par «ligne d'interconnexion commune », une ligne conductrice connectant les mêmes noeuds d'une pluralité de cellules mémoire réparties sur au moins deux plans mémoires. La connexion est réalisée d'une manière directe et sans intermédiaire. Selon un aspect particulier de l'invention, la ligne d'interconnexion commune correspond à la ligne de données commune (bit line en anglais). Selon un aspect particulier de l'invention, la ligne d'interconnexion commune correspond à la ligne de sources commune (source line en anglais).
Selon un aspect particulier de l'invention, le circuit en mémoire comprend une pluralité de plans mémoire de rang i allant de 1 à N, avec N un entier supérieur ou égal à 2.

## Description détaillée

D'autres caractéristiques et avantages de la présente invention apparaîtront mieux à la lecture de la description qui suit en relation aux dessins annexés suivants.

[Fig. 1a] la figure 1a illustre une vue en coupe d'une structure de stockage résistive programmable.

[Fig. 1b] la figure 1b illustre une cellule mémoire utilisée pour réaliser le circuit de calcul en mémoire selon l'invention.

[Fig. 2a] la figure 2a illustre un groupe élémentaire de cellules mémoires selon un premier mode de réalisation de l'invention destiné à réaliser l'opération logique A OU B.

[Fig. 2b] la figure 2b illustre les étapes pour réaliser l'opération logique A OU B avec le groupe élémentaire de cellules mémoires selon le premier mode de réalisation l'invention.

[Fig. 3a] la figure 3a illustre un groupe élémentaire de cellules mémoires selon un second mode de réalisation de l'invention destiné à réaliser l'opération logique A XNOR B.

[Fig. 3b] la figure 3b illustre les étapes pour réaliser l'opération logique A XNOR B avec le groupe élémentaire de cellules mémoires selon le deuxième mode de réalisation de l'invention.

[Fig. 4] la figure 4 illustre les étapes pour réaliser l'opération logique A ET B avec le groupe élémentaire de cellules mémoires selon le premier mode de réalisation de l'invention.

[Fig. 5a] la figure 5a illustre un premier mode de réalisation du circuit de calcul dans la mémoire selon l'invention.

[Fig. 5b] la figure 5b illustre une vue en coupe de la structure en couches minces d'une colonne du circuit de calcul dans la mémoire selon l'invention.

[Fig. 5c] la figure 5c illustre un deuxième mode de réalisation du circuit de calcul dans la mémoire selon l'invention.

[Fig. 6a] la figure 6a illustre un troisième mode de réalisation du circuit de calcul dans la mémoire selon l'invention.

[Fig. 6b] la figure 6b illustre un groupe élémentaire de cellules mémoires selon un quatrième mode de réalisation de l'invention destiné à réaliser un transfert de données.

[Fig. 6c] la figure 6c illustre les étapes pour réaliser un transfert de données avec le groupe élémentaire de cellules mémoires selon le quatrième mode de réalisation l'invention.

[Fig. 7] la figure 7 illustre les étapes exécutées par le circuit de calcul selon l'invention pour calculer le produit au sens des hypervecteurs de trois vecteurs de données.

[Fig. 8] la figure 8 illustre un groupe élémentaire de cellules mémoires selon un troisième mode de réalisation de l'invention destiné à réaliser l'opération logique A OU B.

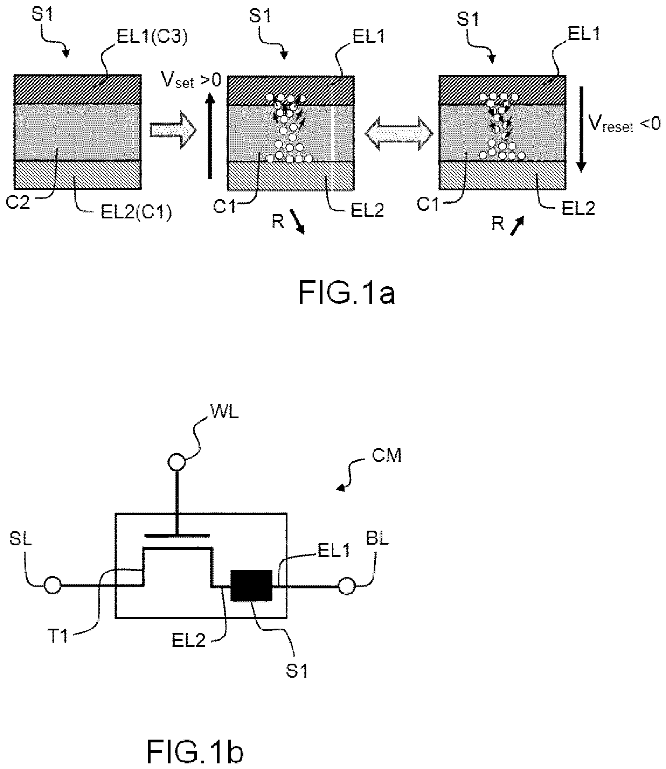

Nous allons commencer par décrire le principe de fonctionnement d'une structure de stockage de données résistive programmable. La figure 1a illustre une vue en coupe d'une structure de stockage résistive programmable. La structure de stockage S1 se compose de l'empilement de couches minces selon l'ordre suivant : au moins une première couche C1 en un matériau électriquement conducteur formant une électrode inférieure EL2 ; une deuxième couche C2 en un matériau diélectrique et au moins une troisième couche C3 en matériau électriquement conducteur formant une électrode supérieure EL1. Les caractéristiques des matériaux constituant les couches de structure mémoire NVM permettent d'obtenir un fonctionnement en mémoire résistive à filament conducteur variable. On dénomme la deuxième couche C2 dans la suite de la description la « couche centrale ».

Alternativement, il est possible de réaliser chaque électrode EL1 et/ou EL2 par un empilement de plusieurs couches conductrices.

À titre d'exemple et sans perte de généralité, la première couche C1 (et donc l'électrode inférieure EL2) et la troisième couche C3 (et donc l'électrode supérieure EL1) sont réalisées en nitrure de titane TiN. L'épaisseur de chacune des couches C1 (EL2) et C3 (EL1) est de l'ordre de quelques dizaines de nanomètres, plus particulièrement égale à 100nm.

À titre d'exemple et sans perte de généralité, la couche centrale C2 est réalisée en oxyde d'hafnium. L'épaisseur de la couche centrale C2 est de l'ordre de quelques nanomètres, plus particulièrement égale à 10nm.

Le fonctionnement d'une structure de stockage S1 résistive nécessite la formation d'un filament conducteur à travers au moins une partie de la couche centrale C2, isolante électriquement.

Initialement, le structure de stockage S1 est une structure de type MIM (métal, isolant, métal) présentant une résistance infinie entre les deux électrodes EL1 et EL2. D'abord, il faut former le filament F à travers au moins une partie du volume de la couche centrale C2. La formation du filament permet d'obtenir une résistance variable en modulant la longueur I du filament conducteur formé. Pour former le filament, on applique une tension électrique positive de formation sur l'électrode supérieure EL1. La tension électrique de formation présente une amplitude et/ou une durée suffisamment élevée afin d'entrainer la génération de lacunes d'oxygène dans la couche centrale C2. En effet, la tension électrique de formation appliquée doit dépasser une valeur prédéterminée de manière à arracher des ions oxygène du réseau cristallin de la couche centrale en oxyde métallique. Les ions vont merger vers l'électrode supérieure EL2 pour former un filament conducteur F à travers la couche centrale constitué des lacunes d'oxygène.

Une fois le filament conducteur F formé, on obtient le comportement d'élément résistif à une résistance variable R selon la longueur du filament conducteur F. Lorsque le potentiel électrique de l'électrode supérieure $V_{EL1}$ est inférieur à celui de l'électrode inférieure $V_{EL2}$, la structure de stockage S1 voit une tension $V_{reset}$ négative à ses bornes. Dans ce cas, des ions oxygènes vont venir combler une partie des lacunes d'oxygène formant le filament conducteur. Il en résulte une réduction de la longueur du filament conducteur. Ainsi, la résistance de l'élément résistif augmente. On parle d'un état résistif haut et d'une opération d'écriture de type RESET. Inversement, lorsque le potentiel électrique de l'électrode supérieure $V_{EL1}$ est supérieur à celui de l'électrode inférieure $V_{EL2}$, la structure de stockage S1 voit une tension $V_{set}$ positive à ses bornes. La longueur du filament conducteur F s'accroît par le même mécanisme décrit pour l'opération de formation du fil. Ainsi, la résistance de l'élément résistif diminue. On parle d'un état résistif bas et d'une opération d'écriture de type SET.

La tension appliquée $V_{set}$ doit être supérieure en valeur absolue à un premier seuil de tension pour passer d'un état résistif haut à un état résistif bas. De même, la tension appliquée $V_{reset}$ doit être supérieure en valeur absolue à un second seuil de tension pour passer d'un état résistif bas à un état résistif haut.

On choisit la convention suivante à titre d'exemple : lorsque la structure de stockage S1 est configurée pour stocker une donnée binaire à l'état logique haut (x= 1) elle est à un état résistif bas. Inversement, lorsque la structure de stockage S1 est configurée pour stocker une donnée binaire à l'état logique bas (x= 0) elle est à un état résistif haut. Une convention inverse est aussi possible.

La figure 1b illustre un schéma électrique d'une cellule mémoire CM selon l'invention. La cellule mémoire CM comprend une structure mémoire S1 et un transistor de sélection T1. La cellule mémoire CM comprend en outre un nœud de sélection WL, un premier nœud d'entrée/sortie SL et un second nœud d'entrée/sortie BL. L'électrode supérieure EL1 de la structure de stockage S1 est connectée au second nœud d'entrée/sortie BL de la cellule mémoire CM. Le nœud de sélection WL est destiné à recevoir un signal de sélection VWL. La grille du transistor T1 est connectée au nœud de sélection WL. Le transistor T2 est monté de manière à relier l'électrode inférieure EL2 au premier nœud d'entrée/sortie SL. Ainsi, la cellule mémoire CM ne peut être écrite en SET ou en RESET que lorsque le transistor T1 est à l'état passant. De plus, le transistor T1 permet de limiter le courant passant à travers la structure de stockage S1 lors d'une opération de SET. La limitation de courant protège la structure S1 du risque de destruction structurelle interne due à la présence des courants forts potentiels lors de la transition d'un état résistif haut à un état résistif bas.

Généralement, il est possible de réaliser dans le cadre de l'invention des cellules mémoires de types OxRAM, CbRAM ou toute autre technologie de mémoire résistive non-volatile.

D'une manière générale, l'invention concerne un circuit de calcul dans la mémoire comprenant une pluralité de plans mémoire de rangs i de 1 à N, avec N un entier naturel supérieur à 1. Chaque plan forme une matrice bidimensionnelle de cellules mémoire CM telles que décrites précédemment. Chaque matrice comprend M lignes et K colonnes de cellules mémoires. On obtient ainsi une structure de mémoires tridimensionnelle. La structure de mémoire tridimensionnelle selon l'invention est caractérisée par l'implémentation d'au moins un groupe élémentaire de plusieurs cellules mémoires aptes à réaliser au moins une opération logique. Nous allons dans ce qui suit décrire plusieurs exemples non limitatifs de modes de réalisation de groupes élémentaires de cellules mémoires.

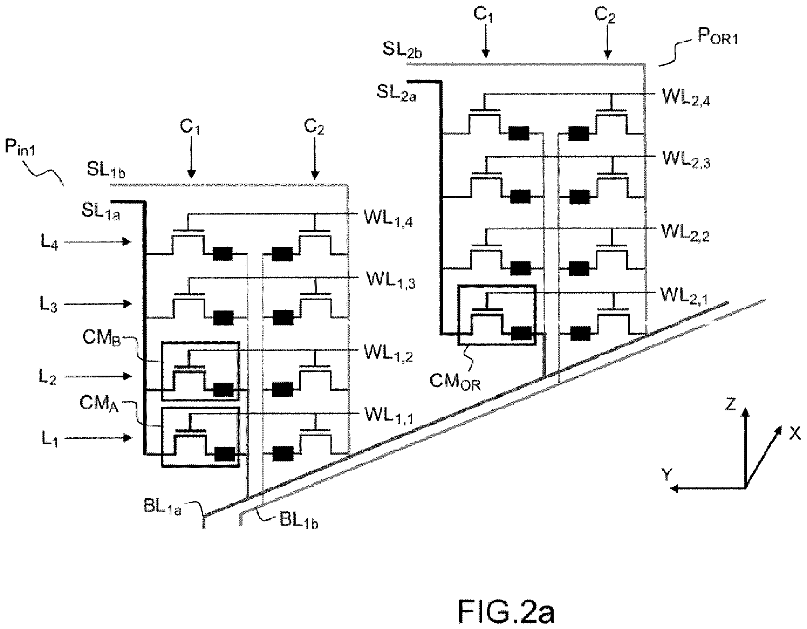

La figure 2a illustre un groupe élémentaire de cellules mémoires selon un premier mode de réalisation de l'invention destiné à réaliser l'opération logique A OU B. Le groupe élémentaire est composé de trois cellules mémoire $CM_A$, $CM_B$, $CM_{OR}$. La première cellule mémoire $CM_A$ appartient au plan mémoire $P_{in1}$ et elle est destinée à stocker une première donnée d'entrée A. La deuxième cellule mémoire $CM_B$ appartient au plan mémoire $P_{in1}$ et elle est destinée à stocker une deuxième donnée d'entrée B. La troisième cellule mémoire $CM_{OR}$ appartient à un plan mémoire $P_{OR1}$ différent du plan mémoire $P_{in1}$. La troisième cellule mémoire est destinée à stocker le résultat de l'opération logique A OU B.

Dans l'exemple illustré, chacun des plans mémoire $P_{in1}$ et $P_{OR1}$ est une matrice de cellules mémoires de quatre lignes ($L_1$, $L_2$, $L_3$, $L_4$) et de deux colonnes ($C_1$, $C_2$). Dans chaque plan mémoire :

- les nœuds de sélection WL des cellules mémoires appartenants à la même ligne $L_j$ sont interconnectés par une ligne de sélection $WL_{ij}$ ;

- les premiers nœuds d'entrée/sorties SL des cellules mémoires appartenants à la même colonne $C_k$ sont interconnectés à travers une ligne de source commune (source line en anglais) ;

- les seconds nœuds d'entrée/sorties BL des cellules mémoires appartenants à la même colonne $C_k$ sont interconnectés par une ligne de données commune (bit line en anglais).

Ainsi, chaque plan mémoire comprend M lignes de sélection $WL_{ij}$ (M étant le nombre de ligne par plan), K lignes de source et K lignes de données (K étant le nombre de colonnes par plan).

Dans le groupe élémentaire illustré, la première cellule mémoire $CM_A$, la deuxième cellule mémoire $CM_B$ et la troisième cellule mémoire $CM_{OR}$ appartiennent toutes à des colonnes de même rang k dans leurs matrices respectives. Les seconds nœuds d'entrée/sortie BL de la première, de la deuxième et des troisièmes cellules mémoire $CM_A$, $CM_B$ et $CM_{OR}$ sont interconnectés par une ligne d'interconnexion commune $BL_{1a}$. La ligne d'interconnexion commune correspond dans ce cas à la ligne de données (bit line en anglais) des cellules mémoire $CM_A$, $CM_B$ et $CM_{OR}$. Ce montage spécifique combiné avec l'application d'une séquence de tension bien déterminée sur les nœuds desdites cellules permet de réaliser la fonction logique A OU B dans la troisième cellule.

Alternativement, il est possible d'implémenter les deux cellules d'entrée $CM_A$ et $CM_B$ dans deux plans mémoires distincts, à condition qu'ils appartiennent à des colonnes de même rang k.

Ainsi, le groupe élémentaire est commandé via les nœuds suivants : le premier nœud d'entrée/sortie commun à $CM_A$ et $CM_B$ noté $SL_{1a}$, le premier nœud d'entrée/sortie de $CM_{OR}$ noté $SL_{2a}$ et les trois nœuds de sélection ($WL_{1,1}$, $WL_{1,2}$ $WL_{2,1}$).

Avantageusement, il est possible de réaliser un autre groupe élémentaire de cellules mémoires symétrique sur les deuxièmes colonnes $C_2$ des plans $P_{in1}$ et $P_{OR1}$ Cela permet de réaliser deux opérations logiques OU sur deux couples d'opérandes différents de manière parallèle.

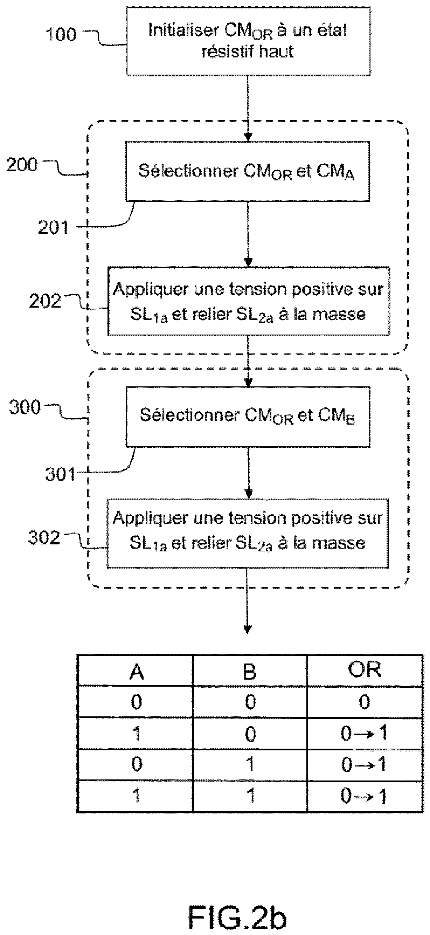

La figure 2b illustre les étapes pour réaliser l'opération logique A OU B avec le groupe élémentaire de cellules mémoires selon le premier mode de réalisation de l'invention.

La première étape 100 consiste à initialiser la troisième cellule $CM_{OR}$ à un état résistif haut correspondant à un état logique bas x=0.

Ensuite, un premier cycle de calcul 200 est déclenché. Le cycle 200 comprend une première étape 201 consistant à sélectionner la première cellule mémoire $CM_A$ et la troisième cellule mémoire $CM_{OR}$ en mettant à l'état passant leurs transistors de sélection T1. La seconde étape 202 du cycle 200 consiste à appliquer une première tension de lecture positive sur le premier nœud d'entrée/sortie $SL_{1a}$ de la première cellule mémoire et connecter simultanément le premier nœud d'entrée/sortie $SL_{2a}$ de la troisième cellule mémoire à la masse électrique.

L'amplitude de la première tension de lecture positive appliquée sur le nœud $SL_{1a}$ est strictement inférieure au second seuil de tension $V_{reset}$ pour passer d'un état résistif bas à un état résistif haut. Cela assure la préservation de l'état résistif de la première cellule mémoire $CM_A$ contenant la première donnée d'entrée. Deux cas de figures sont possibles pour cette configuration :

Dans le premier cas, on considère que la première cellule $CM_A$ est à un état résistif bas (A=1). Cela induit que la chute de tension à travers ladite cellule mémoire est faible. La première cellule mémoire $CM_A$ est assimilable à un interrupteur à l'état passant. La tension appliquée est propagée vers le second nœud d'entrée /sortie BL de la troisième cellule mémoire $CM_{OR}$ par l'intermédiaire de la ligne d'interconnexion commune $BL_{1a}$. Ainsi, la troisième cellule mémoire $CM_{OR}$ se retrouve avec une tension positive sur l'électrode supérieure EL1 connectée à la ligne d'interconnexion $BL_{1a}$, et une tension nulle sur l'électrode inférieure EL2 connectée à la masse à travers le transistor T1 associé à l'état passant. La troisième cellule mémoire $CM_{OR}$ est soumise ainsi à une tension positive à ses bornes. L'amplitude de la première tension de lecture positive appliquée sur le noeud $SL_{1a}$ est strictement supérieure au premier seuil de tension $V_{set}$ pour passer d'un état résistif haut à un état résistif bas. Ainsi, la troisième cellule mémoire $CM_{OR}$ passe d'un état résistif haut (x=0) à un état résistif bas (x=1) lorsque (A=1).

A titre d'exemple, pour une technologie de mémoire résistive déterminée, le premier seuil de tension $V_{set}$ est égale à 1,5V et le deuxième seuil de tension $V_{reset}$ est égal à 2V. L'amplitude de la première tension de lecture positive appliquée sur le noeud $SL_{1a}$ est égale à 1.8V. La première tension de lecture $VSL_{1a}$, est sous forme d'impulsion rectangulaire avec une durée de 100ns à titre d'exemple.

Dans le second cas, on considère que la première cellule $CM_A$ est à un état résistif haut (A=0). Cela induit que la chute de tension à travers ladite cellule mémoire est forte. La première cellule mémoire $CM_A$ est assimilable à un interrupteur à l'état bloquant. La troisième cellule mémoire $CM_{OR}$ se retrouve avec une tension positive proche de zéro sur l'électrode supérieure EL1 et une tension nulle sur l'électrode inférieure EL2 connectée à la masse à travers le transistor T1 associé à l'état passant. La troisième cellule mémoire $CM_{OR}$ est soumise ainsi à une tension faible à ses bornes et non suffisante pour provoquer un changement d'état résistif. Ainsi, la troisième cellule mémoire $CM_{OR}$ reste à son état résistif initialement haut (x=0) lorsque (A=0).

Ensuite, un second cycle de calcul 300 est déclenché. Le cycle 300 comprend une première étape 301 consistant à sélectionner la deuxième cellule mémoire $CM_B$ et la troisième cellule mémoire $CM_{OR}$ en mettant à l'état passant leurs transistors de sélection T1. La seconde étape 302 du cycle 300 consiste à appliquer la première tension de lecture positive sur le premier nœud d'entrée/sortie $SL_{1a}$ de la deuxième cellule mémoire et connecter simultanément le premier nœud d'entrée/sortie $SL_{2a}$ de la troisième cellule mémoire à la masse électrique. Il s'agit d'une réitération du cycle 200 mais en sélectionnant la deuxième cellule mémoire $CM_B$ contenant la seconde donnée d'entrée B. Ainsi, par le même mécanisme décrit dans le premier cycle 200, si la deuxième cellule mémoire $CM_B$ est à un état résistif bas (B=1), alors la troisième cellule mémoire $CM_{OR}$ passe à un état résistif bas (x=1). Si la deuxième cellule mémoire $CM_B$ est à un état résistif haut (B=0), alors la troisième cellule mémoire $CM_{OR}$ reste à un état résistif haut (x=0).

On obtient ainsi, par la séquence d'étapes précédente, la fonction logique suivante : la troisième cellule mémoire $CM_{OR}$ este à un état résistif haut (x=0) si et seulement si la première et la deuxième cellule mémoire $CM_B$, $CM_A$ sont toutes les deux à un état résistif haut. (A=0 et B=0). Cela correspond à la fonction logique A OU B comme illustré dans la table logique de la figure 2b.

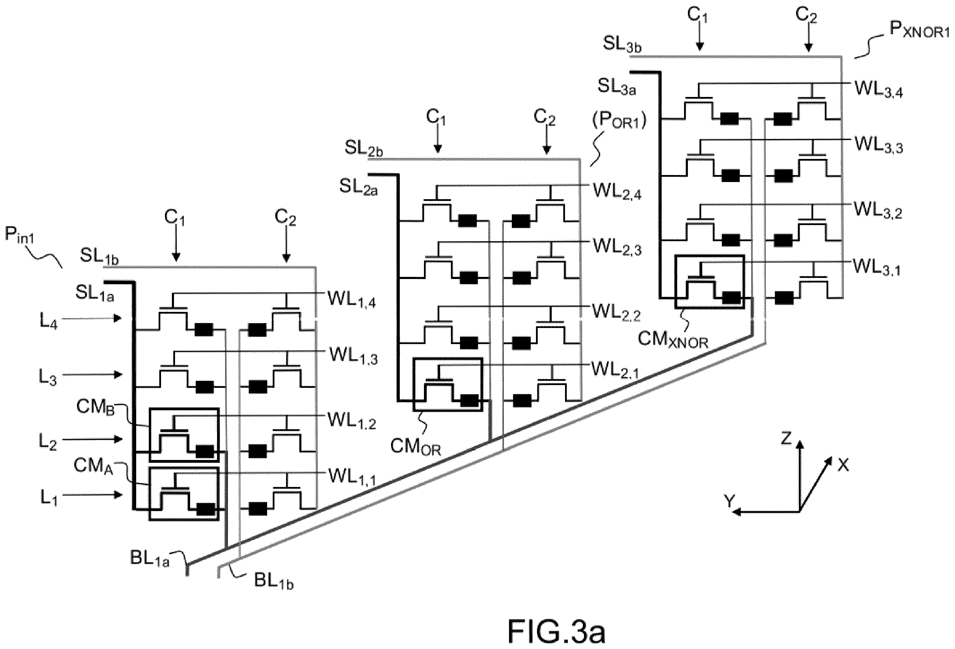

La figure 3a illustre un groupe élémentaire de cellules mémoires selon un second mode de réalisation de l'invention destiné à réaliser l'opération logique A XNOR B. Le deuxième mode de réalisation reprend la même structure du groupe élémentaire selon le premier mode de réalisation et comprend en outre une quatrième cellule mémoire $CM_{XNOR}$. La quatrième cellule mémoire $CM_{XNOR}$ appartient à un plan mémoire $P_{XNOR1}$ différent de celui des plans mémoire $P_{in1}$ et $P_{OR1}$ La quatrième cellule mémoire est destinée à stocker le résultat de la fonction logique (A XNOR B). La première donnée d'entrée A stockée dans $CM_A$, la deuxième donnée d'entrée B stockée dans $CM_B$ et le résultat de (A OR B) préalablement calculé et stocké dans $CM_{OR}$ sont utilisées pour calculer A XNOR B dans $CM_{XNOR}$.

Le second nœud d'entrée/sortie BL de la quatrième cellule mémoire $CM_{XNOR}$ est connecté aux seconds nœuds d'entrée/sortie BL de la première, de la deuxième et de la troisième cellule mémoire $CM_A$, $CM_B$ et $CM_{OR}$ par l'intermédiaire de la ligne d'interconnexion commune $BL_{1a}$.

La quatrième cellule mémoire $CM_{XNOR}$ appartient à la colonne $C_1$ dans la matrice du plan $P_{XNOR1}$. Il s'agit de la colonne de même rang que les cellules mémoires $CM_A$, $CM_B$ et $CM_{OR}$. Cela permet de simplifier l'interconnexion entre les seconds nœuds d'entrée/sortie BL dédites cellules mémoires à travers la ligne d'interconnexion $BL_{1a}$.

Le groupe élémentaire de cellules mémoires selon le second mode de réalisation de l'invention est configurable via : le premier nœud d'entrée/sortie commun à $CM_A$ et $CM_B$ noté $SL_{1a}$, le premier nœud d'entrée/sortie de $CM_{OR}$ noté $SL_{2a}$, le premier nœud d'entrée/sortie de $CM_{XNOR}$ noté $SL_{3a}$ et les quatre noeuds de sélection ($WL_{1,1}$, $WL_{1,2}$ $WL_{2,1}$ $WL_{3,1}$).

Avantageusement, il est possible de réaliser un autre groupe élémentaire de cellules mémoires symétrique sur les deuxièmes colonnes $C_2$ des plans $P_{in1}$ et $P_{OR1}$ Cela permet de réaliser deux opérations logiques OU sur deux couples d'opérandes différents d'une manière parallèle.

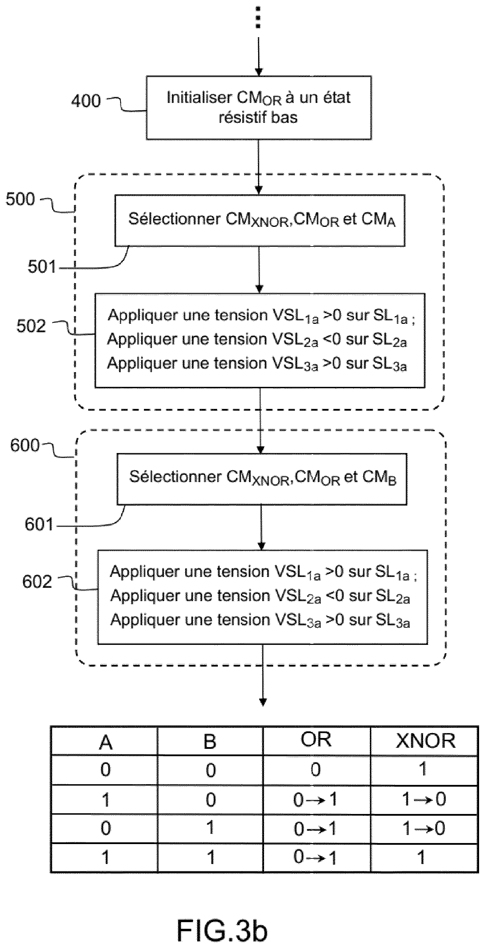

La figure 3b illustre les étapes pour réaliser l'opération logique (A XNOR B) avec le groupe élémentaire de cellules mémoires selon le deuxième mode de réalisation l'invention. Pour réaliser ce calcul le résultat de l'opération logique (A OR B) doit être préalablement calculé et stocké dans la troisième cellule mémoire $CM_{OR}$. Pour cela il est envisageable d'exécuter les étapes du procédé décrit pour le groupe élémentaire selon le premier mode de réalisation de l'invention décrit précédemment. Il est aussi envisageable d'écrire la valeur de l'opération logique (A OR B) dans la troisième cellule mémoire $CM_{OR}$ à partir d'un calculateur externe.

La première étape 400 consiste à initialiser la quatrième cellule $CM_{XNOR}$ à un état résistif bas correspondant à un état logique haut x=1.

Ensuite, un premier cycle de calcul 500 est déclenché. Le cycle 500 comprend une première étape 501 consistant à sélectionner la première cellule mémoire $CM_A$, la troisième cellule mémoire $CM_{OR}$ et la quatrième cellule mémoire $CM_{XNOR}$ en mettant à l'état passant leurs transistors de sélection T1. La seconde étape 502 du cycle 500 consiste à réaliser simultanément :

l'application d'une deuxième tension de lecture positive $VSL_{1a}$ sur le premier nœud d'entrée/sortie $SL_{1a}$ de la première cellule mémoire $CM_A$ ;

l'application d'une troisième tension de lecture négative $VSL_{2a}$ sur le premier nœud d'entrée/sortie $SL_{2a}$ de la troisième cellule mémoire $CM_{OR}$;

et l'application d'une quatrième tension de lecture positive $VSL_{3a}$ sur le premier nœud d'entrée/sortie $SL_{3a}$ de la quatrième cellule mémoire $CM_{XNOR}$ ;

La valeur absolue de la deuxième tension de lecture positive $VSL_{1a}$ est sensiblement égale à celle de la troisième tension de lecture négative $VSL_{2a}$. Avantageusement, la valeur absolue de la deuxième tension de lecture positive $VSL_{1a}$ est légèrement supérieure à celle de la troisième tension de lecture négative $VSL_{2a}$. La différence en valeur absolue entre $VSL_{1a}$ et $VSL_{2a}$ est comprise entre 0% et 40% de la valeur absolue de la troisième tension de lecture $VSL_{2a}$ Plus particulièrement, la différence en valeur absolue entre $VSL_{1a}$ et $VSL_{2a}$ est comprise entre 25% et 35% de la valeur absolue de la troisième tension de lecture $VSL_{2a}$. D'autre part, l'amplitude quatrième tension de lecture positive $VSL_{3a}$ est strictement inférieure au second seuil de tension $V_{reset}$ pour passer d'un état résistif bas à un état résistif haut. Trois cas sont possibles pour cette configuration :

Dans le premier cas, on considère que la première cellule $CM_A$ est à un état résistif bas (A=1) et la troisième cellule $CM_{OR}$ est à un état résistif bas (A OR B=1). La première cellule mémoire $CM_A$ est assimilable à un interrupteur à l'état passant. La deuxième tension de lecture positive $VSL_{1a}$ est propagée vers le second nœud d'entrée /sortie BL de la quatrième cellule mémoire $CM_{XNOR}$ par l'intermédiaire de la ligne d'interconnexion commune $BL_{1a}$. De même, la troisième cellule mémoire $CM_{OR}$ est assimilable à un interrupteur à l'état passant. La troisième tension de lecture négative $VSL_{2a}$ est propagée vers le second nœud d'entrée /sortie BL de la quatrième cellule mémoire $CM_{XNOR}$ par l'intermédiaire de la ligne d'interconnexion commune $BL_{1a}$. Par application de la loi des mailles, le nœud BL de la quatrième cellule $CM_{XNOR}$ présente un potentiel égal à la somme algébrique de $VSL_{2a}$ et $VSL_{1a}$ qui de quelques mV. On obtient ainsi l'équation suivante :

$$VBL_{1a} = VSL_{1a} + VSL_{2a} \approx 0V$$

Ainsi, la quatrième cellule mémoire $CM_{XNOR}$ voit la tension suivante à ces bornes :

$$V_{XNOR} = VBL_{1a} - VSL_{3a} = (VSL_{1a} + VSL_{2a}) - VSL_{3a} \approx -VSL_{3a} < 0 \; ;$$

avec $|VSL_{3a}| < V_{RESET}$

La quatrième cellule mémoire $CM_{XNOR}$ est soumise ainsi à une tension $V_{XNOR}$ négative à ses bornes. L'amplitude de la tension négative $V_{XNOR}$ n'est pas suffisamment élevée pour dépasser le second seuil de tension $V_{reset}$ pour passer d'un état résistif bas à un état résistif haut. Ainsi, la quatrième cellule mémoire $CM_{XNOR}$ reste à un état résistif bas (x=1) lorsque (A=1) et (A OR B=1).

Dans le second cas, on considère que la première cellule $CM_A$ est à un état résistif haut (A=0) et la troisième cellule $CM_{OR}$ est à un état résistif haut (A OR B=0). Aucune des tensions de lecture $VSL_{2a}$ et $VSL_{1a}$ n'est propagée au nœud BL de la quatrième cellule mémoire $CM_{XNOR}$. La quatrième cellule mémoire $CM_{XNOR}$ reste ainsi à son état résistif initial. La quatrième cellule mémoire $CM_{XNOR}$ reste à un état résistif bas (x=1) lorsque (A=0) et (A OR B=0).

Dans le troisième cas, on considère que la première cellule $CM_A$ est à un état résistif haut (A=0) et la troisième cellule $CM_{OR}$ est à un état résistif bas (A OR B=1). La première cellule mémoire $CM_A$ est assimilable à un interrupteur à l'état bloquant. La deuxième tension de lecture positive $VSL_{1a}$ n'est pas propagée vers le second nœud d'entrée /sortie BL de la quatrième cellule mémoire $CM_{XNOR}$. De même, la troisième cellule mémoire $CM_{OR}$ est assimilable à un interrupteur à l'état passant. La troisième tension de lecture négative $VSL_{2a}$ est propagée vers le second nœud d'entrée /sortie BL de la quatrième cellule mémoire $CM_{XNOR}$ par l'intermédiaire de la ligne d'interconnexion commune $BL_{1a}$. On obtient ainsi l'équation suivante :

$$VBL_{1a} = VSL_{2a} < 0V$$

Ainsi, la quatrième cellule mémoire $CM_{XNOR}$ voit la tension suivante à ces bornes :

$$V_{XNOR} = VBL_{1a} - VSL_{3a} = VSL_{2a} - VSL_{3a} < 0 \; ;$$

avec $|V_{XNOR}| = |VSL_{2a}| + |VSL_{3a}| > V_{RESET}$

La troisième cellule mémoire $CM_{OR}$ est soumise ainsi à une tension $V_{XNOR}$ négative à ses bornes. L'amplitude de la tension négative $V_{XNOR}$ est suffisamment élevée pour dépasser le second seuil de tension $V_{reset}$. Ainsi, la quatrième cellule mémoire $CM_{XNOR}$ passe d'un état résistif bas à un état résistif haut (x=0) lorsque (A=0) et (A OR B=1).

Ensuite, un deuxième cycle de calcul 600 est déclenché. Le cycle 600 est une réitération du cycle 500 mais en sélectionnant la deuxième cellule mémoire $CM_B$ contenant la seconde donnée d'entrée B à la place de la première cellule mémoire $CM_A$. Ainsi, par le même mécanisme décrit dans le premier cycle 600, on obtient les trois cas suivants : la quatrième cellule mémoire $CM_{XNOR}$ passe d'un état résistif bas à un état résistif haut (x=0) lorsque (B=0) et (A OR B=1), sinon la quatrième cellule mémoire $CM_{XNOR}$ reste à un état résistif bas (x=1).

On obtient ainsi, par la séquence d'étapes précédente, la fonction logique suivante : la quatrième cellule mémoire $CM_{XNOR}$ passe à un état résistif bas (x=1) si et seulement si la première et la deuxième cellule mémoire $CM_B$, $CM_A$ présentent des états résistifs opposés (A=0 et B=1 ou A=1 et B=0). Cela correspond à la fonction logique A XNOR B comme illustré dans la table logique de la figure 3b.

A titre d'exemple, pour une technologie de mémoire résistive déterminée, le premier seuil de tension $V_{set}$ est égale à 1,8V et le deuxième seuil de tension $V_{reset}$ est égal à 2V. La deuxième tension de lecture $VSL_{1a}$ est égale à 1V. La troisième tension de lecture $VSL_{2a}$ est égale à -0,75V. La quatrième tension de lecture $VSL_{3a}$ est égale à 1,5V. Les tensions de lecture $VSL_{1a}$, $VSL_{2a}$ et $VSL_{3a}$ sont sous forme d'impulsions rectangulaires avec une durée de 100ns à titre d'exemple.

Avantageusement, la tension de sélection $VWL_{3,1}$ appliquée sur la grille du transistor T1 de la quatrième cellule mémoire $CM_{XNOR}$ est inférieure à la tension d'alimentation générale VDD. Cela permet de limiter le courant à travers la cellule mémoire lors d'une transition. Ainsi, on protège la cellule mémoire du risque de détérioration due à la présence des courants forts lors d'une modification de son état résistif.

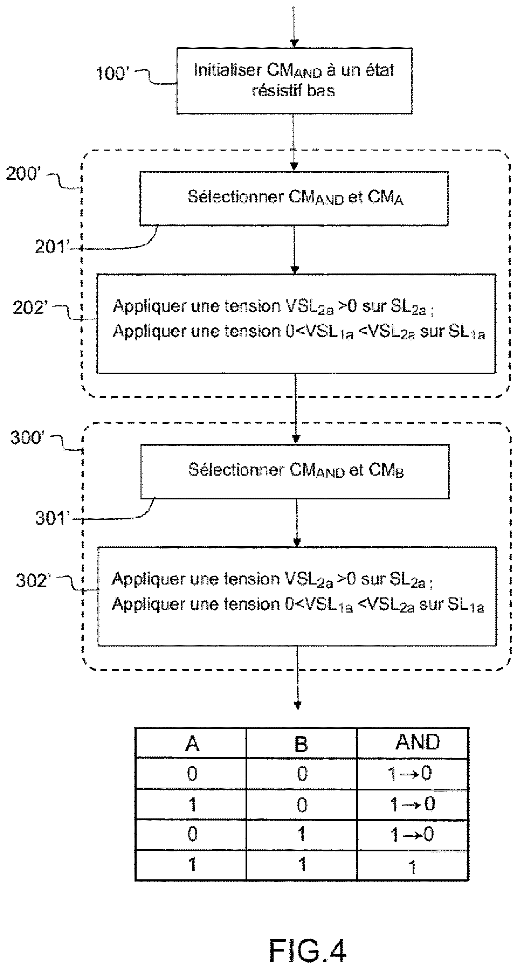

De plus, il est possible de réaliser la fonction logique (A ET B) en utilisant le groupe élémentaire de cellules mémoires selon le premier mode de réalisation. La figure 4 illustre les étapes pour réaliser l'opération logique (A ET B) avec le groupe élémentaire de cellules mémoires selon le premier mode de réalisation l'invention. Dans cette illustration, la troisième cellule mémoire est destinée à stocker le résultat de l'opération logique (A ET B) et elle est dénommée $C_{AND}$ au lieu de $C_{OR}$. La connexion entre les trois cellules mémoires reste inchangée par rapport à la figure 2a.

La première étape 100' consiste à initialiser la troisième cellule $CM_{AND}$ à un état résistif bas correspondant à un état logique haut x=1.

Ensuite, un premier cycle de calcul 200' est déclenché. Le cycle 200' comprend une première étape 201' consistant à sélectionner la première cellule mémoire $CM_A$ et la troisième cellule mémoire $CM_{AND}$ en mettant à l'état passant leurs transistors de sélection T1. La seconde étape 202' du cycle 200 consiste à appliquer une première tension de lecture $VSL_{1a}$ positive sur le premier nœud d'entrée/sortie $SL_{1a}$ de la première cellule mémoire et appliquer une deuxième tension de lecture $VSL_{2a}$ positive sur le troisième nœud d'entrée/sortie $SL_{2a}$ de la troisième cellule mémoire CM$_{AND}$.

L'amplitude de la première tension de lecture VSL$_{1a}$ est strictement inférieure au second seuil de tension V$_{reset}$ pour passer d'un état résistif bas à un état résistif haut. Cela assure la préservation de l'état résistif de la première cellule mémoire CM$_A$ contenant la première donnée d'entrée. L'amplitude de la deuxième tension de lecture VSL$_{2a}$ est strictement supérieure au second seuil de tension V$_{reset}$ pour passer d'un état résistif bas à un état résistif haut. Deux cas de figures sont possibles pour cette configuration :

Dans le premier cas, on considère que la première cellule CM$_A$ est à un état résistif bas (A=1). Cela induit que la chute de tension à travers ladite cellule mémoire est faible. La première cellule mémoire CM$_A$ est assimilable à un interrupteur à l'état passant. La tension appliquée est propagée vers le second nœud d'entrée /sortie BL de la troisième cellule mémoire CM$_{AND}$ par l'intermédiaire de la ligne d'interconnexion commune BL$_{1a}$. Ainsi, la troisième cellule mémoire CM$_{AND}$ voit la tension suivante à ces bornes :

$$V_{AND} = VBL_{1a} - VSL_{2a} \approx VSL_{1a} - VSL_{2a} < 0 \; ; \; \text{avec} \; |V_{AND}| < V_{RESET}$$

La troisième cellule mémoire CM$_{AND}$ est soumise ainsi à une tension V$_{AND}$ négative à ses bornes. L'amplitude de la tension négative V$_{AND}$ n'est pas suffisamment élevée pour dépasser le second seuil de tension V$_{reset}$ et passer d'un état résistif bas à un état résistif haut. Ainsi, la troisième cellule mémoire CM$_{AND}$ reste à un état résistif bas (x=1) lorsque (A=1).

Dans le second cas, on considère que la première cellule CM$_A$ est à un état résistif haut (A=0). Cela induit que la chute de tension à travers ladite cellule mémoire est forte. La première cellule mémoire CM$_A$ est assimilable à un interrupteur à l'état bloquant. Le second nœud d'entrée /sortie BL de la troisième cellule mémoire CM$_{AND}$ une tension VSL$_{1a}$ positive proche de zéro. Ainsi, la troisième cellule mémoire CM$_{AND}$ voit la tension suivante à ces bornes :

$$V_{AND} = VBL_{1a} - VSL_{2a} \approx 0 - VSL_{2a} < 0 \; ; \; \text{avec} \; |V_{AND}| > V_{RESET} \; car \; VBL_{1a} \approx 0$$

La troisième cellule mémoire CM$_{AND}$ est soumise ainsi à une tension V$_{AND}$ négative à ses bornes. L'amplitude de la tension négative V$_{AND}$ est suffisamment élevée pour dépasser le second seuil de tension V$_{reset}$. Ainsi, la troisième cellule mémoire CM$_{AND}$ passe à un état résistif haut (x=0) lorsque (A=0).

Ensuite, un deuxième cycle de calcul 300' est déclenché. Le cycle 300' est une réitération du cycle 200' mais en sélectionnant la deuxième cellule mémoire CM$_B$ contenant la seconde donnée d'entrée B à la place de la première cellule mémoire CM$_A$. Ainsi, par le même mécanisme décrit dans le premier cycle 200', on obtient les deux cas suivants : la troisième cellule mémoire CM$_{AND}$ passe d'un état résistif bas à un état résistif haut (x=0) lorsque (B=0), sinon la troisième cellule mémoire CM$_{AND}$ reste à un état résistif bas (x=1).

On obtient ainsi, par la séquence d'étapes précédente, la fonction logique suivante : la troisième cellule mémoire CM$_{AND}$ reste à un état résistif bas (x=1) si et seulement si la première et la deuxième cellule mémoire CM$_B$, CM$_A$ sont toutes les deux à un état résistif bas. (A=1 et B=1). Cela correspond à la fonction logique A ET B comme illustré dans la table logique de la figure 4.

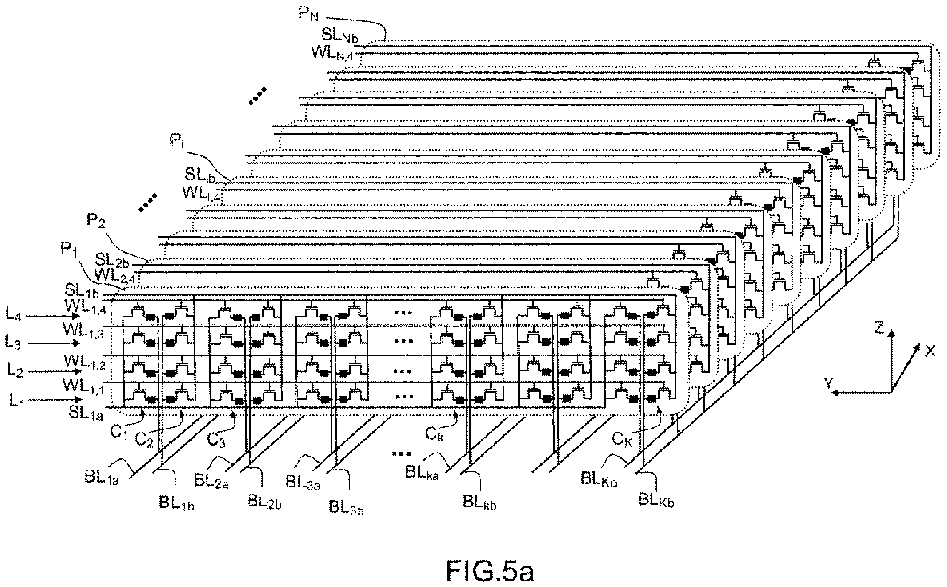

La figure 5a illustre un premier mode de réalisation du circuit de calcul dans la mémoire 10 selon l'invention. Le circuit de calcul 10 comprend une pluralité de plans mémoire successifs P$_i$ de rangs i de 1 à N, avec N un entier naturel supérieur à 1. Chaque plan mémoire forme une matrice bidimensionnelle de cellules mémoire CM selon l'invention. Chaque matrice comprend M lignes L$_j$ et K colonnes C$_k$. À titre d'exemple illustratif, le nombre de lignes par matrice est égal à 4.

Dans chaque plan mémoire P$_i$, les nœuds de sélection WL des cellules mémoires appartenant à la même ligne L$_j$ sont interconnectés par une ligne de sélection WL$_{ij}$ commune.

Dans chaque plan mémoire P$_i$, les premiers nœuds d'entrée/sorties SL des cellules mémoires appartenant à la même colonne C$_k$ sont interconnectés. De plus, les premiers nœuds d'entrée/sortie SL des cellules mémoire appartenant aux colonnes C$_k$ de rangs impairs sont interconnectés formant une première ligne de source SL$_{ia}$ avec i de 1 à N. De plus, les premiers nœuds d'entrée/sortie SL des cellules mémoire appartenant aux colonnes C$_k$ de rangs pairs sont interconnectés formant une seconde ligne de source SL$_{ib}$ avec i de 1 à N.

Dans chaque plan mémoire P$_i$, les seconds nœuds d'entrée/sorties BL des cellules mémoires appartenant à la même colonne C$_k$ sont interconnectés. Les cellules mémoires appartenant à des colonnes de même rangs à travers tous les plans mémoire P$_i$ forment un plan parallèle au plan géométrique (X,Z). Les seconds nœuds d'entrée/sorties BL appartenant à un même plan (X,Z), sont interconnectés par l'intermédiaire d'une ligne d'interconnexion commune. À titre d'exemple, les cellules mémoire des colonnes de rang 1 de tous les plans mémoire sont interconnectés via la ligne d'interconnexion BL$_{1a}$. Les cellules mémoire des colonnes de rang 2 de tous les plans mémoire sont interconnectées via la ligne d'interconnexion BL$_{1b}$.

On obtient ainsi une structure tridimensionnelle de mémoires non-volatile comprenant une pluralité de groupes élémentaires selon l'invention aptes à réaliser des opérations logiques de type OU, ET et toute autre opération logique réalisable à partir des opérations élémentaires OU et ET.

Avantageusement, il est envisageable de dédier un plan $P_i$ pour stocker les opérandes d'entrée. Il est envisageable de dédier un plan $P_i$, quelconque de la structure pour stocker les résultats d'une opération logique mettant en œuvre les différentes combinaisons des opérandes d'entrée. Cela offre une flexibilité de programmation que les structures usuelles de circuit de calcul en mémoire ne présentent pas.

D'une manière générale, le circuit de calcul 10 selon l'invention présente l'avantage suivant : Toutes les cellules d'un même plan (XZ) ont la même ligne d'interconnexion commune $BL_{ia}$. Ainsi, n'importe quelle cellule mémoire CM de ce plan (XZ) peut être utilisée pour stocker un opérande. Le résultat peut être stocké dans n'importe quelle autre cellule mémoire du plan (XZ), à l'exception des colonnes comprenant les données d'entrée. Cela laisse une grande liberté de programmation et de stockage des données dans le circuit de calcul 10.

De plus, lorsqu'une opération logique est réalisée en parallèle sur tous les plans (XZ), n'importe quelle cellule mémoire peut être ouverte ou fermée grâce à un nœud de sélection indépendant $WL_{ij}$. Les lignes de sélection $WL_{ij}$ sont indépendantes à l'intérieur d'un même plan (XZ), toutes les cellules inutilisées pendant une opération logique seront fermées. Cela permet de limiter les courants de fuite dans les colonnes de rang j à travers tous les plans mémoire $P_i$. A titre d'exemple, les transistors T1 sont de type grille enrobante (Gate-All-Around en anglais) si les cellules mémoires sont de type OxRAM. Cela limite les courants de fuite par cellule mémoire CM à $10^{-11}$ A. Il est alors possible d'implémenter à l'intérieur d'un même plan (XZ) $10^7$ cellules mémoires. Il en résulte une augmentation considérable des capacités de stockage et de calcul immergé dans la structure mémoire par rapport aux solutions de l'état de l'art.

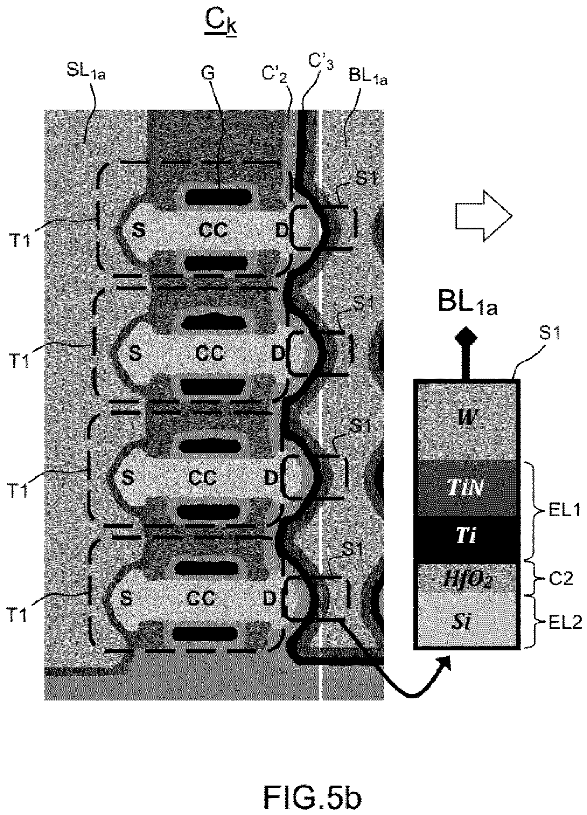

La figure 5b illustre une vue en coupe d'un mode de réalisation de la structure en couches minces d'une colonne $C_k$ de quatre cellules mémoires CM du circuit de de calcul dans la mémoire 10 selon l'invention. Les matériaux utilisés sont présentés à titre d'illustration non limitatif.

La colonne $C_k$ comprend un premier pilier métallique pour réaliser la ligne de source commune $SL_{1a}$ et un second pilier métallique pour réaliser la ligne d'intersection commune $BL_{1a}$. La colonne comprend en outre un empilement de quatre transistors indépendants de type grille enrobante (Gate-All-Around en anglais) séparés par un matériau isolant IS1. Chaque transistor correspond au transistor de sélection T1 d'une cellule mémoire. Chaque transistor comprend un canal de conduction CC en silicium ayant une première extrémité correspondant au drain et une seconde extrémité correspondant à la source. L'utilisation des transistors de type grille enrobante permet de réduire considérablement les courants de fuite de la structure. De plus, les transistors de type grille enrobante présentent la possibilité d'être empilés les uns au-dessus des autres afin de réaliser une structure dense selon l'invention. La paroi latérale du côté des drains de l'ensemble des transistors est recouverte d'une succession de couches. La succession de couches comprend dans cet ordre une première couche en un matériau diélectrique C'2 tel que l'oxyde d'hafnium ($HfO_2$), puis une première couche métallique C'3 en Titane (Ti), puis une deuxième couche métallique en nitrure de titane (TiN) par exemple. La succession de couches obtenue au niveau de chaque drain d'un transistor T1 forme une structure de stockage résistive S1 correspondant à l'empilement de la figure 1a. L'électrode supérieure EL1 se compose de l'ensemble de la première couche métallique en Titane et la deuxième couche métallique en nitrure de titane. La couche centrale C2 est la couche en oxyde d'hafnium. L'électrode inférieure EL2 correspond à l'extrémité du canal du transistor T1. Avantageusement, il est envisageable de déposer une couche métallique supplémentaire entre l'extrémité du canal du transistor T1 et la première couche en un matériau diélectrique C'2 pour améliorer le contact électrique au niveau de l'électrode inférieure EL2.

Un transistor T1 et la structure de stockage résistive S1 qui lui est connectée forment ensemble une cellule mémoire CM selon l'invention. On réalise ainsi un empilement de quatre cellules mémoires CM.

La colonne $C_k$ est obtenue par la réalisation de l'agencement suivant : le premier pilier métallique $SL_{1a}$ en contact avec toutes les secondes extrémités correspondant à la source ; et le second pilier métallique $BL_{1a}$ mis en contact avec l'ensemble des électrodes supérieures EL1.

La structure présentée dans la figure 5b permet d'implémenter physiquement le circuit selon l'invention avec une densité géométrique améliorée par rapport aux solutions connues. Plus particulièrement, le circuit de calcul dans la mémoire selon l'invention permet d'implémenter une pluralité de cellules mémoire de type 1T1R (un transistor et une résistance) avec une structure tridimensionnelle plus compacte par rapport aux solutions connues.

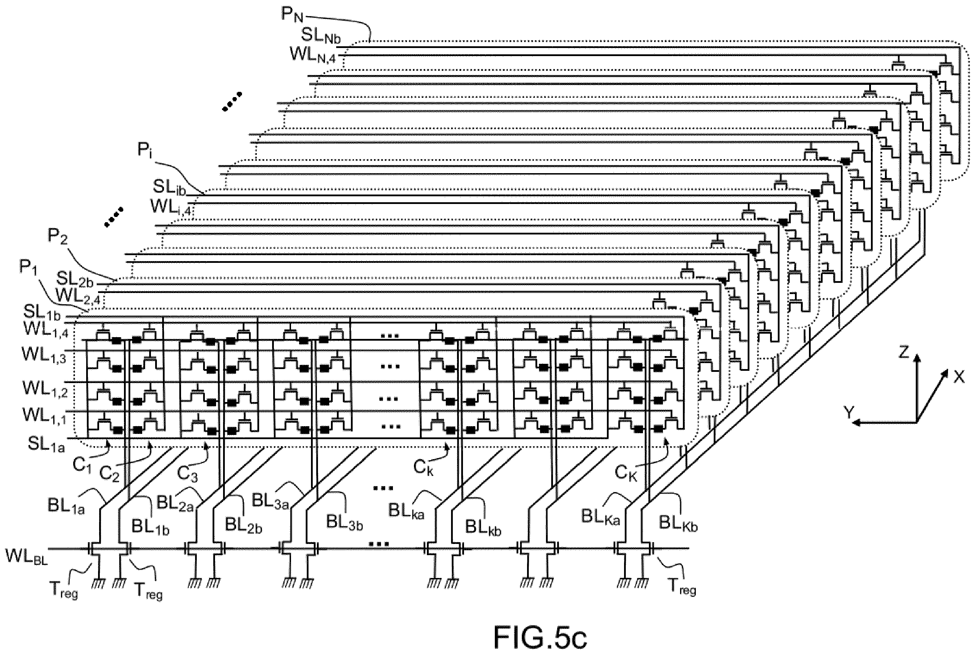

La figure 5c illustre un deuxième mode de réalisation du circuit de calcul dans la mémoire selon l'invention. Dans ce mode de réalisation le circuit de calcul dans la mémoire 10 comprend en outre pour chaque ligne d'interconnexion ($BL_{1a}$, $BL_{1b}$ $BL_{2a}$ $BL_{2b}$) un transistor de contrôle $T_{reg}$. Chaque transistor de régulation $T_{reg}$ présente une grille recevant un signal de régulation $VWL_{BL}$. Chaque transistor de régulation $T_{reg}$ reliant la ligne d'interconnexion $BL_{1a}$ associée à la masse électrique ou à une tension d'alimentation du circuit de calcul, de manière à réaliser une impédance variable. Le contrôle de l'impédance est réalisé via le signal de régulation $VWL_{BL}$ généré par les moyens de contrôle du circuit de calcul 10. Cela permet de contrôler indirectement le ratio du pont diviseur obtenu par les cellules mémoires formant un groupe élémentaire. Plus particulièrement, lorsque le transistor de régulation $T_{reg}$ est un transistor NMOS, le transistor relie la ligne d'interconnexion $BL_{1a}$ associée à la masse électrique pour baisser ladite impédance. Lorsque le transistor de régulation $T_{reg}$ est un transistor PMOS, ledit transistor relie la ligne d'interconnexion $BL_{1a}$ associée à un nœud connecté à la tension d'alimentation VDD du circuit de calcul pour augmenter ladite impédance.

**EP 4 224 477 B1**

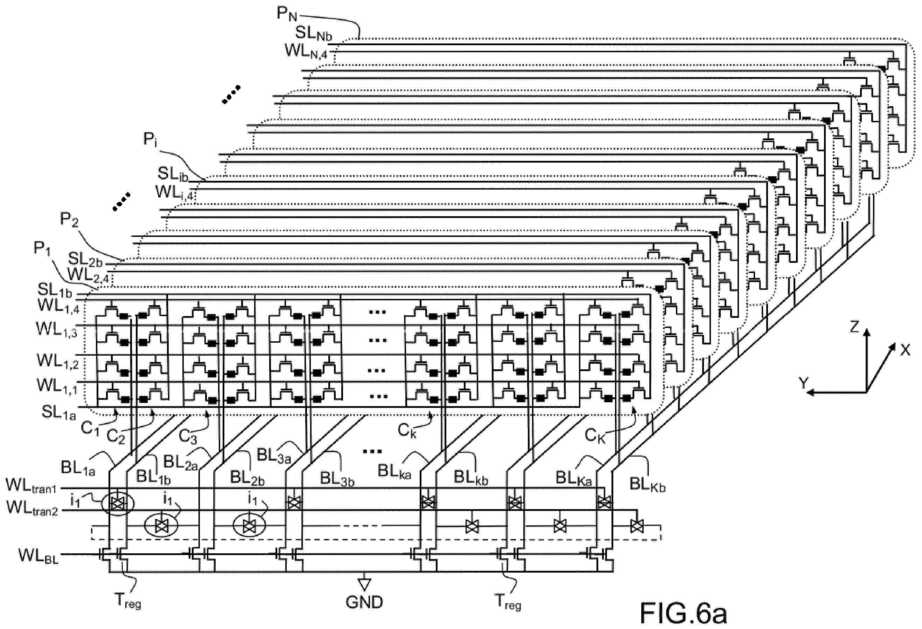

La figure 6a illustre un troisième mode de réalisation du circuit de calcul dans la mémoire selon l'invention. Dans ce mode de réalisation, le circuit de calcul dans la mémoire 10 est tel que chaque ligne d'interconnexion $BL_{ia}$ est connectée à la ligne d'intersection suivante $BL_{ib}$ par l'intermédiaire d'un interrupteur i1. À titre d'exemple l'interrupteur i1 est réalisé par une grille de passage (pass-gate en anglais) formée par deux transistors complémentaires. L'ouverture et la fermeture de la grille de passage est commandée par des signaux complémentaires $WL_{trans1}$ et $WL_{tran2}$ générés par les moyens de contrôle du circuit 10. L'ensemble des interrupteurs i1 permettent de réaliser une fonction de transfert du contenu stocké dans une cellule mémoire à une autre cellule mémoire d'un plan mémoire différent.

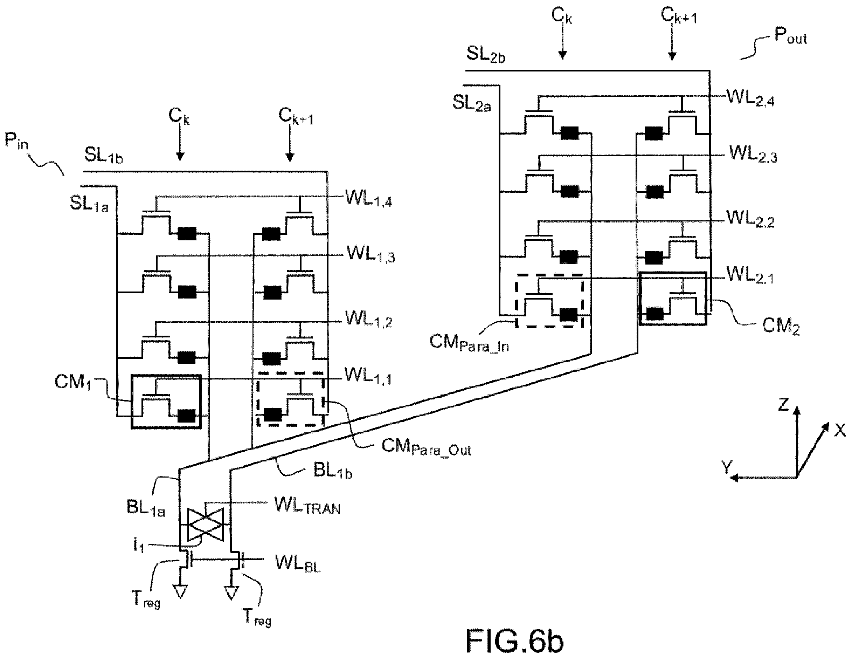

La figure 6b illustre un groupe élémentaire de cellules mémoires selon un quatrième mode de réalisation de l'invention destiné à réaliser un transfert de données.

La cellule mémoire de départ CM1 appartient à une colonne quelconque de rang k $C_k$ d'un premier plan $P_{in}$. La cellule mémoire d'arrivée (de destination) CM2 appartient à une colonne de rang k+1 ou k-1 d'un second plan $P_{out}$ différent. La ligne d'interconnexion commune $BL_{1a}$ connectée à la cellule mémoire de départ $CM_1$ est connectée à la ligne d'interconnexion $BL_{1b}$ connectée à la cellule mémoire d'arrivée $CM_2$ via une grille de passage.

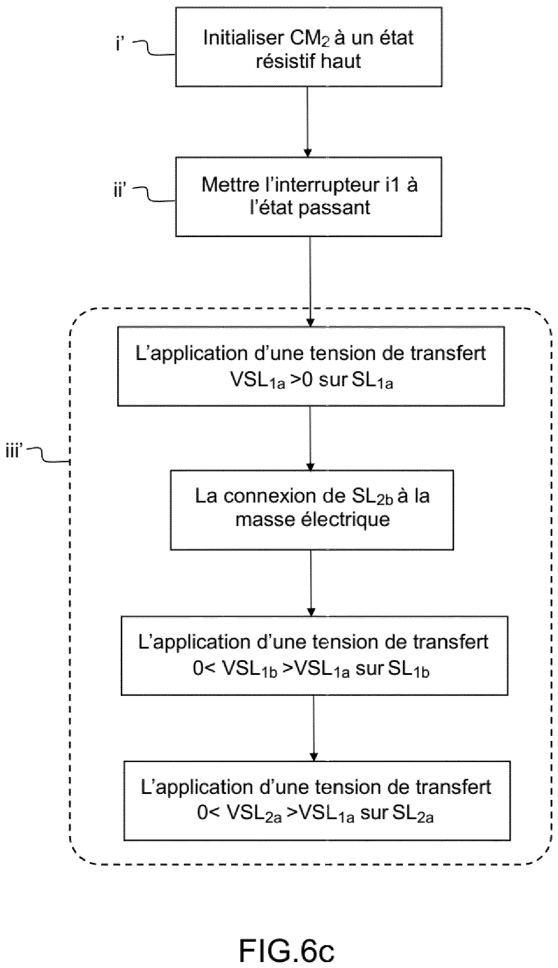

La figure 6c illustre les étapes pour réaliser un transfert de données avec le groupe élémentaire de cellules mémoires selon le quatrième mode de réalisation de l'invention. Le procédé de transfert décrit permet un transfert de données tout en protégeant le contenu des cellules mémoires $CM_{par\_out}$ et $CM_{par\_in}$ pouvant être impactées par le transfert. La cellule mémoire $CM_{par\_in}$ appartient au même plan de la cellule mémoire de départ et est connectée à la même ligne d'interconnexion de la cellule mémoire d'arrivée $CM_{par\_out}$.

Les moyens de contrôle sont configurés pour réaliser le transfert d'une donnée stockée d'une cellule mémoire de départ $CM_1$ à une cellule mémoire d'arrivée $CM_2$.

La première étape i' consiste à initialiser la cellule d'arrivée (CM2) à un état résistif haut.

L'étape suivante ii' consiste à mettre l'interrupteur i1 à l'état passant de manière à connecter électriquement la ligne d'interconnexion $BL_{1a}$ et la ligne d'interconnexion $BL_{1b}$.

L'étape suivante iii' consiste à réaliser simultanément les opérations suivantes :

a. l'application d'une première tension de transfert $VSL_{1a}$ positive sur le premier nœud d'entrée/sortie $SL_{1a}$ de la cellule mémoire de départ $CM_1$ ;

b. la connexion du premier nœud d'entrée/sortie $SL_{2b}$ de la cellule mémoire d'arrivée $CM_2$ à la masse électrique ;

c. l'application d'une seconde tension de transfert $VSL_{1b}$ positive sur le premier nœud d'entrée/sortie $SL_{1b}$ de la cellule mémoire $CM_{par\_in}$ ;

d. l'application de la seconde tension de transfert positive sur le premier nœud d'entrée/sortie $VSL_{2a}$ de la cellule mémoire $CM_{par\_out}$ ;

L'amplitude de première tension de transfert $VSL_{1a}$ est suffisamment élevée pour provoquer un passage à un état résistif bas de la cellule mémoire d'arrivée $CM_2$ lorsque la cellule mémoire de départ est à un état résistif bas (x=1). L'amplitude de la seconde tension de transfert $VSL_{1b}$ positive est choisie de manière à obtenir dans tous les cas une tension inférieure aux tensions de seuil $V_{set}$ et $V_{reset}$ aux bornes de $CM_{par\_in}$ et $CM_{par\_out}$. Ainsi, le contenu de ces deux cellules est préservé lors du transfert. A titre d'exemple, la première tension de transfert $VSL_{1a}$ est choisie égale à la tension d'alimentation VDD. La seconde tension de transfert $VSL_{1b}$ est égale à la moitié de la tension d'alimentation VDD.

Nous avons ainsi démontré la possibilité de réaliser un transfert de données d'un plan mémoire à un autre du circuit de calcul dans la mémoire 10 selon l'invention.

Nous allons décrire, dans ce qui suit, un exemple d'une application algorithmique du circuit de calcul dans la mémoire 10 selon l'invention. Les algorithmes de calcul hyper-dimensionnel (Hyperdimensional Computing en anglais) présentent des applications intéressantes du circuit de calcul dans la mémoire selon l'invention. Ce paradigme de calcul repose sur la manipulation de vecteurs de données de grande taille appelés hypervecteurs (ayant D coordonnées avec D>1000). Il est possible d'utiliser cette approche pour la classification de textes par langage: un texte est lu séquentiellement lettre par lettre. Chaque lettre est associée à un hypervecteur différent. Tous les hypervecteurs des lettres du texte sont alors combinés entre eux grâce aux opérations élémentaires de multiplication (via la fonction XNOR), d'addition et de permutation (via la fonction de transfert) pour créer un hypervecteur unique associé au texte. L'hypervecteur du texte permet ensuite de reconnaître la langue du texte par comparaison avec des hypervecteurs références.

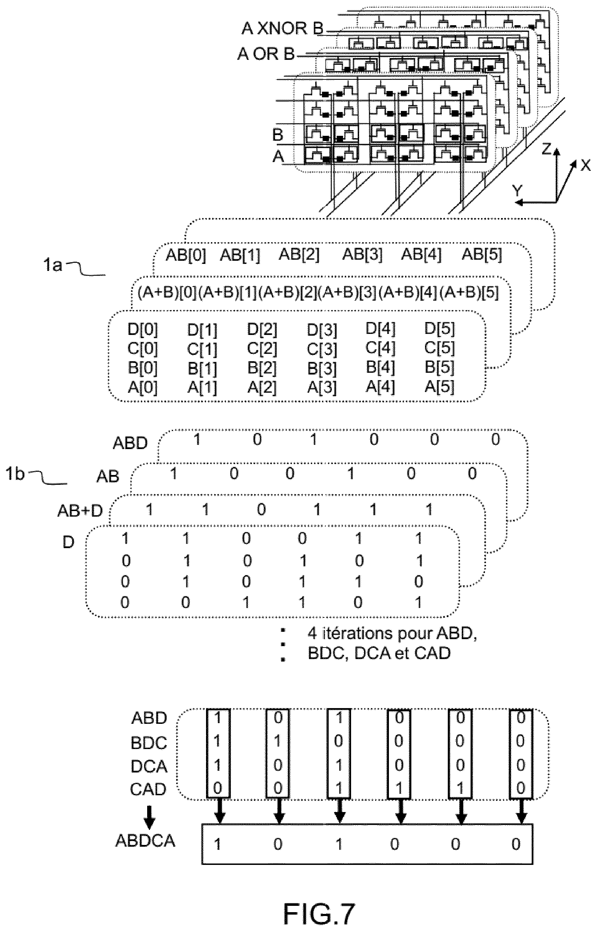

La figure 7 illustre les étapes exécutées par le circuit de calcul 11 selon l'invention pour calculer l'hypervecteur $\underline{O}$ résultant des hypervecteurs d'entrée suivants :

$\underline{A}$=(A[0], A[1], A[2], A[3], A[4], A[5])
$\underline{B}$=(B[0], B[1], B[2], B[3], B[4], B[5])

C=(C[0], C[1], C[2], C[3], C[4], C[5])

D=(D[0], D[1], D[2], D[3], D[4], D[5])

L'hypervecteur résultant est défini par O= ABDCAD = ABD+BDC+DCA+CAD.

le produit entre deux hypervecteurs A et B est défini de la manière suivante :

AB=(A[0]B[0], A[1]B[1], A[2]B[2], A[3]B[3], A[4]B[4], A[5]B[5])

À titre d'exemple, le circuit de calcul dans la mémoire 11 est dimensionné de la manière suivante : il comprend quatre plans mémoire ($P_1$, $P_2$, $P_3$, $P_4$). Chaque plan comprend quatre lignes et six colonnes. Le premier plan $P_1$ est destiné à stocker les hypervecteurs d'entrée. Le deuxième plan $P_2$ est destiné à stocker les résultats des opérations logiques OR. Le troisième plan $P_3$ est destiné à stocker les résultats des opérations logiques XNOR. Le quatrième plan $P_4$ est destiné à stocker les coordonnées des résultats intermédiaires ABD, BDC, DCA et CAD. L'opération logique A[i] OR B[i] correspond à la sommation binaire A[i] + B[i]. L'opération logique A[i] XNOR B[i] correspond à la multiplication binaire A[i].B[i].

Initialement, chaque ligne du premier plan mémoire $P_1$ stocke les coordonnées d'un hypervecteur d'entrée A, B, C, ou D.

Pendant l'étape 1a, le circuit de calcul 11 est configuré pour calculer parallèlement dans la première ligne du deuxième plan $P_2$ les résultats (A+B)[i] = A[i] OR B[i]. Ensuite, le circuit de calcul 11 est configuré pour calculer parallèlement dans la première ligne du troisième plan $P_3$ les résultats (A.B)[i] = A[i] XNOR B[i].

Pendant l'étape suivante 1b, le circuit de calcul 11 est configuré pour calculer parallèlement dans la première ligne du deuxième plan $P_2$ les résultats (AB+D)[i] = AB[i] OR D[i]. Ensuite, le circuit de calcul 11 est configuré pour calculer parallèlement dans la première ligne du quatrième plan $P_4$ les résultats (A.B.D)[i] = AB[i] XNOR D[i]. Les coordonnées du vecteur AB étant calculées et stockées dans les cellules mémoire du troisième plan $P_3$ au cours de l'étape 1a.

On obtient ainsi, les coordonnées du vecteur ABD dans la première ligne du quatrième plan $P_4$.

Ensuite, la séquence d'étapes est réitérée pour calculer les coordonnées du vecteur BDC dans la deuxième ligne du quatrième plan $P_4$.

Ensuite, la séquence d'étapes est réitérée pour calculer les coordonnées du vecteur DCA dans la troisième ligne du quatrième plan $P_4$.

Ensuite, la séquence d'étapes est réitérée pour calculer les coordonnées du vecteur CAD dans la quatrième ligne du quatrième plan $P_4$.

On obtient enfin sur le quatrième plan $P_4$ les coordonnées des trigrammes ABD, BDC, DCA et CAD. La dernière étape consiste à calculer la somme de chaque colonne pour générer l'hypervecteur résultant O comme illustré.

D'une manière générale, les différents modes de réalisation du circuit de calcul dans la mémoire selon l'invention permettent d'exécuter tout type d'algorithme impliquant des opérations logiques booléennes élémentaires de type OR et AND. De plus, l'homme du métier peut implémenter des opérations logiques booléennes plus complexes à partir des résultats desdites opérations logiques booléennes élémentaires préalablement décrites.

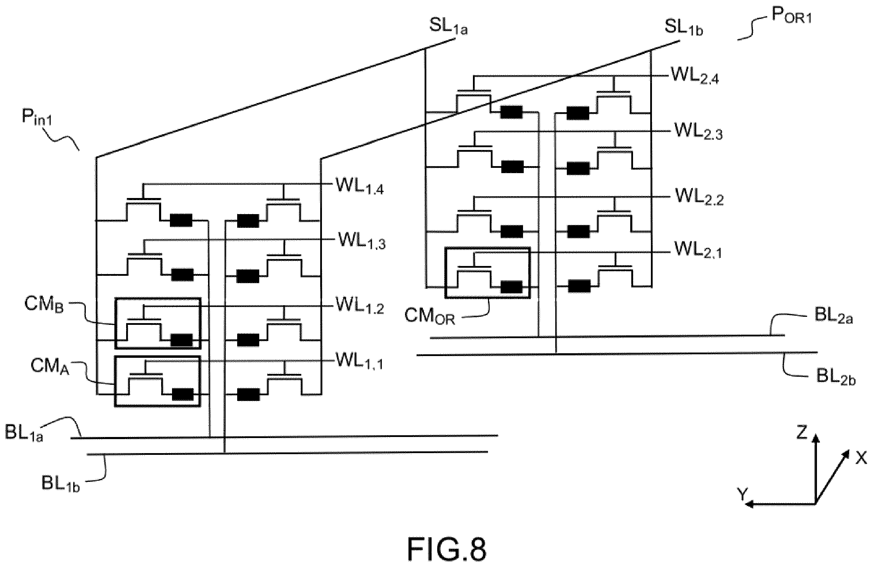

La figure 8 illustre un groupe élémentaire de cellules mémoires selon un troisième mode de réalisation de l'invention destiné à réaliser l'opération logique A OU B. Le groupe élémentaire selon le troisième mode de réalisation se distingue de celui du premier mode de réalisation par ce qui suit : Les premiers nœuds d'entrée/sortie SL de la première, de la deuxième et des troisièmes cellules mémoire $CM_A$, $CM_B$ et $CM_{OR}$ sont interconnectés par une ligne d'interconnexion commune $SL_{1a}$. La ligne d'interconnexion commune correspond dans ce cas à la ligne de sources (source line en Anglais) des cellules mémoire $CM_A$, $CM_B$ et $CM_{OR}$.

Dans le groupe élémentaire illustré, la première cellule mémoire $CM_A$, la deuxième cellule mémoire $CM_B$ et la troisième cellule mémoire $CM_{OR}$ appartiennent toutes à des colonnes de même rang dans leurs matrices respectives. Dans le même plan mémoire, les seconds nœuds d'entrée/sorties BL des cellules mémoires appartenant à la même colonne $C_k$ sont interconnectés par une ligne de données commune (bit line en anglais). Ce mode de réalisation peut être utilisé pour réaliser des opérations logiques de type OU, ET en appliquant un jeu de tension prédéterminée de la façon similaire à ce qui est décrit pour le premier mode de réalisation.

Références :

[1] Memory devices and applications for in-memory computing, A. Sebastian, Nature nanotechnology 2020.

[2] Four-Layer 3D Vertical RRAM Integrated with FinFET as a Versatile Computing Unit for Brain-Inspired Cognitive Information Processing, H.Li, et al., Symposium on VLSI Technology Digest of Technical Papers, 2016

[3] Innovative 3D Technology of a nonvolatile memory cell for In-Memory-Computing, Théophile Dubreuil.

**Revendications**

1. Circuit de calcul dans la mémoire (10) comprenant une pluralité de plans mémoire ($P_i$) de rang i allant de 1 à N, avec N un entier naturel supérieur à 1, chaque plan formant une matrice bidimensionnelle de cellules mémoire non volatiles, résistives et programmables, chaque cellule mémoire ayant un nœud de sélection (WL), un premier nœud d'entrée/sortie (SL) et un second nœud d'entrée/sortie (BL) ; ladite matrice comprenant M lignes ($L_j$) de rang j allant de 1 à M et K colonnes ($C_k$) de rang k allant de 1 à K, avec M et K deux entiers naturels non nuls; ledit circuit de calcul (10) comprenant :

   - des moyens de contrôle configurés pour commander les noeuds des cellules mémoire pour réaliser des opérations de stockage et de calcul en mémoire réalisées par le circuit de calcul ;
   - au moins un groupe élémentaire de cellules mémoires comprenant :

       ◦ une première cellule mémoire ($CM_A$) appartenant à l'un quelconque des plans mémoire ($P_{in1}$) et destinée à stocker une première donnée d'entrée (A) ;
       ◦ une deuxième cellule mémoire ($CM_B$) appartenant à l'un quelconque des plans mémoire ($P_{in1}$) et destinée à stocker une deuxième donnée d'entrée (B) ;
       ◦ une troisième cellule mémoire ($CM_{OR}$, $CM_{AND}$) appartenant à un plan mémoire ($P_{OR1}$) différent de celui de la première et la deuxième cellules mémoire ($CM_A$ $CM_b$); la troisième cellule mémoire étant destinée à stocker le résultat d'une première opération logique ayant pour opérandes la première et la deuxième données d'entrée ;

   la première, deuxième et troisième cellules mémoire ($CM_A$, $CM_B$ $CM_{OR}$) appartenant à des colonnes ($C_k$) de même rang k dans leurs matrices respectives ;
   la première, la deuxième et la troisième cellules mémoire ($CM_A$, $CM_B$, $CM_{OR}$) étant interconnectées par une ligne d'interconnexion commune ($BL_{1a}$, $SL_{1a}$) ; ladite ligne d'interconnexion commune connectant l'un à l'autre les premiers nœuds d'entrée/sortie (SL) des cellules mémoire dudit groupe élémentaire ou les seconds nœuds d'entrée/sortie (BL) des cellules mémoire dudit groupe élémentaire ;
   pour chaque plan mémoire ($P_i$) :

       les nœuds de sélection (WL) des cellules mémoires appartenant à la même ligne ($L_j$) sont interconnectés par une ligne de sélection ($WL_{ij}$) ;
       les premiers nœuds d'entrée/sorties (SL) des cellules mémoires appartenant à la même colonne ($C_k$) sont interconnectés ;

       les seconds nœuds d'entrée/sorties (BL) des cellules mémoires appartenant à la même colonne ($C_k$) sont interconnectés.

2. Circuit de calcul dans la mémoire (10) selon la revendication 1 dans lequel chaque cellule mémoire ($CM_A$, $CM_B$, $CM_{OR}$) comprend :

   - une structure de stockage résistive programmable ayant :

       • une électrode supérieure (EL1) connectée au second nœud d'entrée/sortie (BL) de ladite cellule mémoire ($CM_A$, $CM_B$, $CM_{OR}$) ;
       • et une électrode inférieure (EL2) ;

   - un transistor de sélection (T1) ayant une grille connectée au nœud de sélection (WL) de ladite cellule mémoire et reliant l'électrode inférieure (EL2) au premier nœud d'entrée/sortie (SL) de ladite cellule mémoire ($CM_A$, $CM_B$, $CM_{OR}$).

3. Circuit de calcul dans la mémoire (10) selon la revendication 2 dans lequel chaque colonne ($C_k$) de cellules mémoire (CM) comprend :

   - Un empilement d'une pluralité de transistors de sélection (T1) selon une première direction ($\Delta$) ;

       chaque transistor de sélection, notamment de type grille enrobante, comprenant un canal de conduction (CC), perpendiculaire à la première direction ($\Delta$) en un matériau semiconducteur et ayant deux extrémités ;

la première extrémité du canal correspondant à la source du transistor de sélection et la seconde correspondant au drain du transistor ;

- un premier pilier métallique ($SL_{1a}$) selon la première direction ($\Delta$) connectant les sources des différents transistors de sélection ;
- une couche en diélectrique (C'2) parallèle à la première direction ($\Delta$) et couvrant latéralement les drains des transistors de sélection ;
- au moins une couche métallique (C'3) en parallèle à la première direction déposée sur la couche en diélectrique ;
- un second pilier métallique ($BL_{1a}$) selon la première direction ($\Delta$) ayant un contact latéral avec l'au moins couche métallique ;

pour chaque transistor de sélection, l'ensemble formé par le drain, la couche en diélectrique (C'2) et la couche métallique (C'3) constitue une structure de stockage résistive (S1).

4. Circuit de calcul dans la mémoire (10) selon l'une quelconque des revendications précédentes tel que pour chaque plan mémoire ($P_{in1}$, $P_{OR1}$) :

les premiers nœuds d'entrée/sortie (SL) des cellules mémoire appartenant aux colonnes ($C_k$) de rangs impairs sont interconnectés formant une première ligne de source ($SL_{1a}$) ;
les premiers nœuds d'entrée (SL) des cellules mémoire appartenant aux colonnes ($C_k$) de rangs pairs sont interconnectés formant une seconde ligne de source ($SL_{1b}$) ;
la première ligne de source et la seconde ligne de source étant distinctes ;

5. Circuit de calcul dans la mémoire (10) selon l'une quelconque des revendications 1 à 4 dans lequel le groupe élémentaire de cellules mémoires comprend en outre une quatrième cellule mémoire ($CM_{XNOR}$) appartenant à un plan mémoire différent de celui de la première, deuxième et troisième cellules mémoire ($CM_A$ $CM_b$, $CM_{OR}$); la quatrième cellule mémoire étant destinée à stocker le résultat d'une deuxième opération logique ayant pour opérandes la première et la deuxième données d'entrée et utilisant le résultat de la première opération logique stocké dans la troisième cellule mémoire ($CM_{OR}$) ;
la quatrième cellule mémoire ($CM_{XNOR}$) étant connectée à la première, à la deuxième et à la troisième cellules mémoire ($CM_A$, $CM_B$, $CM_{OR}$) via la ligne d'interconnexion commune ($BL_{1a}$, $SL_{1a}$).

6. Circuit de calcul dans la mémoire (10) selon l'une quelconque des revendications 1 à 5 dans lequel pour chaque groupe élémentaire de cellules mémoires, la ligne d'interconnexion ($BL_{1a}$) connecte l'un à l'autre les seconds nœuds d'entrée/sortie (BL) des cellules mémoire dudit groupe élémentaire.

7. Circuit de calcul dans la mémoire (10) selon l'une quelconque des revendications 1 à 6 dans lequel les moyens de contrôle sont configurés pour réaliser les étapes suivantes afin de réaliser la fonction logique OU :

i- Initialiser la troisième cellule à un état résistif haut ;
ii- sélectionner la première et la troisième cellule mémoire ($CM_A$, $CM_{OR}$) en mettant à l'état passant leurs transistors de sélection (T1) ;
iii- appliquer une première tension de lecture positive sur le premier nœud d'entrée/sortie ($SL_{1a}$) de la première cellule mémoire et connecter simultanément le premier nœud d'entrée/sortie ($SL_{2a}$) de la troisième cellule mémoire à la masse électrique ;
iv- sélectionner la deuxième et la troisième cellule mémoire ($CM_B$, $CM_{OR}$) en mettant à l'état passant leurs transistors de sélection (T1) ;
v- appliquer la première tension de lecture positive sur le premier nœud d'entrée/sortie ($SL_{1a}$) de la première cellule mémoire et connecter simultanément le premier nœud d'entrée/sortie ($SL_{2a}$) de la troisième cellule mémoire à la masse électrique ;

chaque cellule mémoire présentant:

un premier seuil de tension ($V_{set}$) pour passer d'un état résistif haut à un état résistif bas ; et un second seuil de tension ($V_{reset}$) pour passer d'un état résistif bas à un état résistif haut supérieur au premier seuil de tension ($V_{set}$) ;
ladite première tension de lecture étant positive avec une amplitude supérieure ou égale au premier seuil de passage et strictement inférieure au second seuil de passage.

8. Circuit de calcul dans la mémoire (10) selon l'une quelconque des revendications 1 à 6dans lequel les moyens de contrôle sont configurés pour réaliser les étapes suivantes afin de réaliser la fonction logique NON-OU exclusive (XNOR) :

i- Initialiser la quatrième cellule à un état résistif bas ;
ii- sélectionner la première, la troisième et la quatrième cellule mémoire ($CM_A$, $CM_{OR}$, $CM_{XNOR}$) en mettant à l'état passant leurs transistors ;
iii- réaliser simultanément :

a- l'application d'une deuxième tension de lecture positive ($VSL_{1a}$) sur le premier nœud d'entrée/sortie ($SL_{1a}$) de la première cellule mémoire ($CM_A$) ;
b- l'application d'une troisième tension de lecture négative ($VSL_{2a}$) sur le premier nœud d'entrée/sortie ($SL_{2a}$) de la troisième cellule mémoire ($CM_{OR}$) ;
c- et l'application d'une quatrième tension de lecture positive ($VSL_{3a}$) sur le premier nœud d'entrée/sortie ($SL_{3a}$) de la quatrième cellule mémoire ($CM_{XNOR}$) ;

iv- sélectionner la deuxième, la troisième et la quatrième cellule mémoire ($CM_B$, $CM_{OR}$, $CM_{XNOR}$) en mettant à l'état passant leurs transistors de sélection (T1) ;
v- réaliser simultanément :

a- l'application de la deuxième tension de lecture positive ($VSL_{1a}$) sur le premier nœud d'entrée/sortie ($SL_{1a}$) de la deuxième cellule mémoire ($CM_B$) ;
b- l'application de la troisième tension de lecture négative ($VSL_{2a}$) sur le premier nœud d'entrée/sortie ($SL_{2a}$) de la troisième cellule mémoire ($CM_{OR}$) ;
c- et l'application d'une quatrième tension de lecture positive ($VSL_{3a}$) sur le premier nœud d'entrée/sortie ($SL_{3a}$) de la quatrième cellule mémoire ($CM_{XNOR}$) ;

la valeur absolue de la troisième tension de lecture ($VSL_{2a}$) étant sensiblement égale à la valeur absolue de la deuxième tension de lecture ($VSL_{1a}$) ;
la somme de la valeur absolue de la quatrième tension de lecture ($VSL_{3a}$) et de la troisième tension de lecture ($VSL_{2a}$) étant supérieure au second seuil de passage ($V_{reset}$).

9. Circuit de calcul dans la mémoire (10) selon l'une quelconque des revendications 1 à 6 dans lequel les moyens de contrôle sont configurés pour réaliser les étapes suivantes afin de réaliser la fonction logique ET :

i- Initialiser la troisième cellule à un état résistif haut ;
ii- sélectionner la première et la troisième cellule mémoire ($CM_A$, $CM_{AND}$) en mettant à l'état passant leurs transistors de sélection (T1) ;
iii- appliquer une première tension de lecture ($VSL_{1a}$) positive sur le premier nœud d'entrée/sortie ($SL_{1a}$) de la première cellule mémoire et appliquer une deuxième tension de lecture ($VSL_{2a}$) positive sur le troisième nœud d'entrée/sortie ($SL_{2a}$) de la troisième cellule mémoire ($CM_{AND}$) ;
iv- sélectionner la deuxième et la troisième cellule mémoire ($CM_B$, $CM_{AND}$) en mettant à l'état passant leurs transistors de sélection (T1) ;
v- appliquer la première tension de lecture ($VSL_{1a}$) positive sur le premier nœud d'entrée/sortie ($SL_{1a}$) de la première cellule mémoire et appliquer la deuxième tension de lecture ($VSL_{2a}$) positive sur le troisième nœud d'entrée/sortie ($SL_{2a}$) de la troisième cellule mémoire ($CM_{AND}$) ;

chaque cellule mémoire présentant:

un premier seuil de tension ($V_{set}$) pour passer d'un état résistif haut à un état résistif bas ; et un second seuil de tension ($V_{reset}$) pour passer d'un état résistif bas à un état résistif haut supérieur au premier seuil de tension ($V_{set}$) ;
ladite première tension de lecture ($VSL_{1a}$) ayant une amplitude strictement inférieure au second seuil de tension ($V_{reset}$) ; ladite seconde tension de lecture ($VSL_{2a}$) ayant une amplitude strictement supérieure au second seuil de tension ($V_{reset}$).

10. Circuit de calcul dans la mémoire (10) selon l'une quelconque des revendications précédentes comprenant pour chaque ligne d'interconnexion ($BL_{1a}$, $BL_{1b}$ $BL_{2a}$ $BL_{2b}$) un transistor de régulation ($T_{reg}$) ; chaque transistor de régulation ($T_{reg}$) ayant une grille recevant un signal de régulation ($VWL_{BL}$) et reliant la ligne d'interconnexion associée à la masse électrique ou à une tension d'alimentation (VDD) du circuit de calcul, de manière à réaliser une impédance variable.

11. Circuit de calcul dans la mémoire (10) selon l'une quelconque des revendications précédentes comprenant une pluralité de groupes élémentaires de cellules mémoires ; chaque ligne d'interconnexion ($BL_{1a}$, $BL_{1b}$ $BL_{2a}$ $BL_{2b}$) étant connectée à une ligne d'interconnexion ($BL_{1a}$, $BL_{1b}$ $BL_{2a}$ $BL_{2b}$) adjacente par l'intermédiaire d'un interrupteur (i1).

12. Circuit de calcul dans la mémoire (10) selon la revendication 11 dans lequel les moyens de contrôle sont configurés pour réaliser le transfert d'une donnée stockée d'une cellule mémoire de départ ($CM_1$) à une cellule mémoire d'arrivée ($CM_2$) appartenant à un plan différent de celui de la cellule mémoire de départ et connectée à une ligne d'interconnexion adjacente à celle de la cellule mémoire de départ ;
le transfert est réalisé en exécutant les étapes suivantes :

    i'- initialiser la cellule d'arrivée (CM2) à un état résistif haut ;
    ii'- mettre l'interrupteur i1 à l'état passant
    iii'- réaliser simultanément :

        a. l'application d'une première tension de transfert positive sur le premier nœud d'entrée/sortie ($SL_{1a}$) de la cellule mémoire de départ ($CM_1$) ;
        b. la connexion du premier nœud d'entrée/sortie ($SL_{2b}$) de la cellule mémoire d'arrivée à la masse électrique ;
        c. l'application d'une seconde tension de transfert positive sur le premier nœud d'entrée/sortie ($SL_{1b}$) de la cellule mémoire ($CM_{par\_in}$) appartenant au même plan de la cellule mémoire de départ et connectée à la même ligne d'interconnexion de la cellule mémoire d'arrivée ;
        d. l'application de la seconde tension de transfert positive sur le premier nœud d'entrée/sortie ($SL_{2a}$) de la cellule mémoire ($CM_{par\_out}$) appartenant au même plan de la cellule mémoire d'arrivée et connectée à la même ligne de bits de la cellule mémoire de départ ;

l'amplitude de la seconde tension de transfert étant inférieure ou égale à la moitié de la première tension de transfert.

13. Circuit de calcul dans la mémoire (10) selon l'une quelconque des revendications 1 à 5 dans lequel, pour chaque groupe élémentaire de cellules mémoires, la ligne d'interconnexion ($SL_{1a}$) connecte l'un à l'autre les premiers nœuds d'entrée/sortie (SL) des cellules mémoire dudit groupe élémentaire.

## Patentansprüche

1. Berechnungsschaltkreis im Speicher (10), umfassend eine Vielzahl von Speicherebenen ($P_i$) der Ordnung i von 1 bis N, wobei N eine natürliche Zahl größer als 1 ist, wobei jede Ebene eine zweidimensionale Matrix aus nichtflüchtigen, resistiven und programmierbaren Speicherzellen bildet, wobei jede Speicherzelle einen Auswahlanschluss (WL), einen ersten Ein-/Ausgabeanschluss (SL) und einen zweiten Ein-/Ausgabeanschluss (BL) aufweist, und wobei die besagte Matrix M Zeilen ($L_j$) der Ordnung j von 1 bis M und K Spalten ($C_k$) der Ordnung k von 1 bis K umfasst, wobei M und K zwei natürliche Zahlen mindestens 1 sind; wobei der besagte Berechnungsschaltkreis (10) umfasst:

    - eine Steuereinrichtung, konfiguriert zum Steuern der Anschlüsse der Speicherzellen, um durch den Berechnungsschaltkreis realisierte Speicher- und Berechnungsoperationen durchzuführen;
    - mindestens eine Elementargruppe von Speicherzellen, umfassend:

        - eine erste Speicherzelle ($CM_A$), die zu einer beliebigen der Speicherebenen ($P_{in1}$) gehört und zum Speichern eines ersten Eingabedatums (A) bestimmt ist;
        - eine zweite Speicherzelle ($CM_B$), die zu einer beliebigen der Speicherebenen ($P_{in1}$) gehört und zum Speichern eines zweiten Eingabedatums (B) bestimmt ist;
        - eine dritte Speicherzelle ($CM_{OR}$, $CM_{AND}$), die zu einer anderen Speicherebene ($P_{OR1}$) als die der ersten und zweiten Speicherzelle ($CM_A$ $CM_b$) gehört; wobei die dritte Speicherzelle zum Speichern des Ergebnisses einer ersten logischen Operation mit dem ersten und dem zweiten Eingabedatum als Operanden bestimmt ist;

    wobei die erste, zweite und dritte Speicherzelle ($CM_A$, $CM_B$, $CM_{OR}$) zu Spalten ($C_k$) derselben Ordnung k in ihren jeweiligen Matrizen gehören;

wobei die erste, die zweite und die dritte Speicherzelle ($CM_A$, $CM_B$, $CM_{OR}$) durch eine gemeinsame Verbindungsleitung ($BL_{1a}$, $SL_{1a}$) miteinander verbunden sind; wobei die besagte gemeinsame Verbindungsleitung die ersten Ein-/Ausgabeanschlüsse (SL) der Speicherzellen der besagten elementaren Gruppe oder die zweiten Ein-/Ausgabeanschlüsse (BL) der Speicherzellen der besagten elementaren Gruppe miteinander verbindet; wobei für jede Speicherebene ($P_i$):

die Auswahlanschlüsse (WL) der Speicherzellen, die zu derselben Zeile ($L_j$) gehören, durch eine Auswahlleitung ($WL_{ij}$) miteinander verbunden sind;
die ersten Ein-/Ausgabeanschlüsse (SL) der Speicherzellen, die zu derselben Spalte ($C_k$) gehören, miteinander verbunden sind;
die zweiten Ein-/Ausgabeanschlüsse (BL) der Speicherzellen, die zu derselben Spalte ($C_k$) gehören, miteinander verbunden sind.

2. Berechnungsschaltkreis im Speicher (10) nach Anspruch 1, wobei jede Speicherzelle ($CM_A$, $CM_B$, $CM_{OR}$) umfasst:

- eine programmierbare resistive Speicherstruktur mit:

- einer oberen Elektrode (EL1), die mit dem zweiten Ein-/Ausgabeanschluss (BL) der besagten Speicherzelle ($CM_A$, $CM_B$, $CM_{OR}$) verbunden ist;
- und einer unteren Elektrode (EL2);

- einen Auswahltransistor (T1) mit einem Gate, der mit dem Auswahlanschluss (WL) der besagten Speicherzelle verbunden ist, und der die untere Elektrode (EL2) mit dem ersten Ein-/Ausgabeanschluss (SL) der besagten Speicherzelle ($CM_A$, $CM_B$, $CM_{OR}$) verbindet.

3. Berechnungsschaltkreis im Speicher (10) nach Anspruch 2, wobei jede Spalte ($C_k$) von Speicherzellen (CM) umfasst:

- Einen Stapel einer Vielzahl von Auswahltransistoren (T1) entlang einer ersten Richtung ($\Delta$);

wobei jeder Auswahltransistor, insbesondere mit allseitig umschließendem Gate, einen Leitungskanal (CC) aufweist, senkrecht zur ersten Richtung ($\Delta$) in einem Halbleitermaterial und mit zwei Enden;
wobei das erste Ende des Kanals der Source des Auswahltransistors entspricht und das zweite Ende der Drain des Auswahltransistors entspricht;

- eine erste metallische Säule ($SL_{1a}$) entlang der ersten Richtung ($\Delta$) die die Sources der verschiedenen Auswahltransistoren verbindet;
- eine dielektrische Schicht (C'2) parallel zur ersten Richtung ($\Delta$), die die Drains der Auswahltransistoren seitlich bedeckt;
- mindestens eine metallische Schicht (C'3) parallel zur ersten Richtung, die auf der dielektrischen Schicht abgeschieden ist;
- eine zweite metallische Säule ($BL_{1a}$) entlang der ersten Richtung ($\Delta$), die einen seitlichen Kontakt mit der mindestens einen metallischen Schicht aufweist;

wobei für jeden Auswahltransistor die aus Drain, dielektrischer Schicht (C'2) und metallischer Schicht (C'3) gebildete Anordnung eine resistive Speicherstruktur (S1) bildet.

4. Berechnungsschaltkreis im Speicher (10) nach einem der vorhergehenden Ansprüche, wobei für jede Speicherebene ($P_{in1}$, $P_{OR1}$) :

die ersten Ein-/Ausgabeanschlüsse (SL) der Speicherzellen, die zu Spalten ($C_k$) ungerader Ordnung gehören, miteinander verbunden sind und eine erste Source-Leitung ($SL_{1a}$) bilden;
die ersten Ein-/Ausgabeanschlüsse (SL) der Speicherzellen, die zu Spalten ($C_k$) gerader Ordnung gehören, miteinander verbunden sind und eine zweite Source-Leitung ($SL_{1b}$) bilden;
wobei die erste Source-Leitung und die zweite Source-Leitung unterschiedlich sind.

5. Berechnungsschaltkreis im Speicher (10) nach einem der Ansprüche 1 bis 4, wobei die elementare Gruppe von Speicherzellen weiter umfassend eine vierte Speicherzelle ($CM_{XNOR}$), die zu einer anderen Speicherebene als die der ersten, zweiten und dritten Speicherzelle ($CM_A$ $CM_b$, $CM_{OR}$) gehört; wobei die vierte Speicherzelle zum Speichern des Ergebnisses einer zweiten logischen Operation mit dem ersten und dem zweiten Eingabedatum als Operanden und unter Verwendung des Ergebnisses der ersten logischen Operation, gespeichert in der dritten Speicherzelle ($CM_{OR}$) bestimmt ist;

wobei die vierte Speicherzellle ($CM_{XNOR}$) mit der ersten, der zweiten und der dritten Speicherzelle ($CM_A$, $CM_B$, $CM_{OR}$) über die gemeinsame Verbindungsleitung ($BL_{1a}$, $SL_{1a}$) verbunden ist.

6. Berechnungsschaltkreis im Speicher (10) nach einem der Ansprüche 1 bis 5, wobei für jede elementare Gruppe von Speicherzellen die Verbindungsleitung ($BL_{1a}$) die zweiten Ein-/Ausgabeanschlüsse (BL) der Speicherzellen der besagten elementaren Gruppe miteinander verbindet.

7. Berechnungsschaltkreis im Speicher (10) nach einem der Ansprüche 1 bis 6, wobei die Steuereinrichtung konfiguriert ist, um die folgenden Schritte durchzuführen, um die logische ODER-Funktion zu realisieren:

   i- Initialisieren der dritten Zelle auf einen hohen resistiven Zustand;

   ii- Auswählen der ersten und der dritten Speicherzelle ($CM_A$, $CM_{OR}$) durch Schließen ihrer Auswahltransistoren (T1);

   iii- Anlegen einer positiven ersten Lesespannung an den ersten Ein-/Ausgabeanschluss ($SL_{1a}$) der ersten Speicherzelle und gleichzeitiges Verbinden des ersten Ein-/Ausgabeanschlusses ($SL_{2a}$) der dritten Speicherzelle mit elektrischer Masse;

   iv- Auswählen der zweiten und der dritten Speicherzelle ($CM_B$, $CM_{OR}$) durch Schließen ihrer Auswahltransistoren (T1);

   v- Anlegen der positiven ersten Lesespannung an den ersten Ein-/Ausgabeanschluss ($SL_{1a}$) der ersten Speicherzelle und gleichzeitiges Verbinden des ersten Ein-/Ausgabeanschlusses ($SL_{2a}$) der dritten Speicherzelle mit elektrischer Masse;

   wobei jede Speicherzelle aufweist:

   eine erste Schwellspannung ($V_{set}$) für den Übergang von einem hohen resistiven Zustand zu einem niedrigen resistiven Zustand; und eine zweite Schwellspannung ($V_{reset}$) für den Übergang von einem niedrigen resistiven Zustand zu einem hohen resistiven Zustand, die höher als die erste Schwellspannung ($V_{set}$) ist;

   wobei die besagte erste Lesespannung positiv ist mit einer Amplitude größer oder gleich der ersten Schwellspannung und streng kleiner als die zweite Schwellspannung.

8. Berechnungsschaltkreis im Speicher (10) nach einem der Ansprüche 1 bis 6, wobei die Steuereinrichtung konfiguriert ist, um die folgenden Schritte durchzuführen, um die logische Exklusiv-NICHT-ODER-Funktion (XNOR) zu realisieren:

   i- Initialisieren der vierten Zelle auf einen niedrigen resistiven Zustand;

   ii- Auswählen der ersten, der dritten und der vierten Speicherzelle ($CM_A$, $CM_{OR}$, $CM_{XNOR}$) durch Schließen ihrer Transistoren;

   iii- Gleichzeitiges Durchführen der folgenden Schritte:

   a- Anlegen einer positiven zweiten Lesespannung ($VSL_{1a}$) an den ersten Ein-/Ausgabeanschluss ($SL_{1a}$) der ersten Speicherzelle (CMA) ;

   b- Anlegen einer negativen dritten Lesespannung ($VSL_{2a}$) an den ersten Ein-/Ausgabeanschluss ($SL_{2a}$) der dritten Speicherzelle ($CM_{OR}$) ;

   c- und Anlegen einer positiven vierten Lesespannung ($VSL_{3a}$) an den ersten Ein-/Ausgabeanschluss ($SL_{3a}$) der vierten Speicherzelle ($CM_{XNOR}$) ;

   iv- Auswählen der zweiten, der dritten und der vierten Speicherzelle ($CM_B$, $CM_{OR}$, $CM_{XNOR}$) durch Schließen ihrer Auswahltransistoren (T1);

   v- Gleichzeitiges Durchführen der folgenden Schritte:

   a- Anlegen der positiven zweiten Lesespannung ($VSL_{1a}$) an den ersten Ein-/Ausgabeanschluss ($SL_{1a}$) der zweiten Speicherzelle ($CM_B$) ;

   b- Anlegen der negativen dritten Lesespannung ($VSL_{2a}$) an den ersten Ein-/Ausgabeanschluss ($SL_{2a}$) der dritten Speicherzelle ($CM_{OR}$) ;

   c- und Anlegen der positiven vierten Lesespannung ($VSL_{3a}$) an den ersten Ein-/Ausgabeanschluss ($SL_{3a}$)

der vierten Speicherzelle ($CM_{XNOR}$) ;

wobei der Absolutwert der dritten Lesespannung ($VSL_{2a}$) im Wesentlichen gleich dem Absolutwert der zweiten Lesespannung ($VSL_{1a}$) ist;

wobei die Summe aus dem Absolutwert der vierten Lesespannung ($VSL_{3a}$) und der dritten Lesespannung ($VSL_{2a}$) größer als die zweite Schwellspannung ($V_{reset}$) ist.

9. Berechnungsschaltkreis im Speicher (10) nach einem der Ansprüche 1 bis 6, wobei die Steuereinrichtung konfiguriert ist, um die folgenden Schritte durchzuführen, um die logische UND-Funktion zu realisieren:

i- Initialisieren der dritten Zelle auf einen hohen resistiven Zustand;
ii- Auswählen der ersten und der dritten Speicherzelle ($CM_A$, $CM_{AND}$) durch Schließen ihrer Auswahltransistoren (T1);
iii- Anlegen einer positiven ersten Lesespannung ($VSL_{1a}$) an den ersten Ein-/Ausgabeanschluss ($SL_{1a}$) der ersten Speicherzelle und Anlegen einer positiven zweiten Lesespannung ($VSL_{2a}$) an den dritten Ein-/Ausgabeanschluss ($SL_{2a}$) der dritten Speicherzelle ($CM_{AND}$);
iv- Auswählen der zweiten und der dritten Speicherzelle ($CM_B$, $CM_{AND}$) durch Schließen ihrer Auswahltransistoren (T1);
v- Anlegen der positiven ersten Lesespannung ($VSL_{1a}$) an den ersten Ein-/Ausgabeanschluss ($SL_{1a}$) der ersten Speicherzelle und Anlegen der positiven zweiten Lesespannung ($VSL_{2a}$) an den dritten Ein-/Ausgabeanschluss ($SL_{2a}$) der dritten Speicherzelle ($CM_{AND}$) ;

wobei jede Speicherzelle aufweist:

eine erste Schwellspannung ($V_{set}$) für den Übergang von einem hohen resistiven Zustand zu einem niedrigen resistiven Zustand; und eine zweite Schwellspannung ($V_{reset}$) für den Übergang von einem niedrigen resistiven Zustand zu einem hohen resistiven Zustand, die höher als die erste Schwellspannung ($V_{set}$) ist; wobei die besagte erste Lesespannung ($VSL_{1a}$) eine Amplitude streng kleiner als die zweite Schwellspannung ($V_{reset}$) aufweist; wobei die besagte zweite Lesespannung ($VSL_{2a}$) eine Amplitude streng größer als die zweite Schwellspannung ($V_{reset}$)·aufweist.

10. Berechnungsschaltkreis im Speicher (10) nach einem der vorhergehenden Ansprüche, umfassend für jede Verbindungsleitung ($BL_{1a}$, $BL_{1b}$ $BL_{2a}$ $BL_{2b}$) einen Regeltransistor ($T_{reg}$); wobei jeder Regeltransistor ($T_{reg}$) einen Gate-Anschluss aufweist, der ein Regelsignal ($VWL_{BL}$) empfängt und die zugehörige Verbindungsleitung mit elektrischer Masse oder einer Versorgungsspannung (VDD) des Berechnungsschaltkreises verbindet, um so eine variable Impedanz zu realisieren.

11. Berechnungsschaltkreis im Speicher (10) nach einem der vorhergehenden Ansprüche, umfassend eine Vielzahl von elementaren Gruppen von Speicherzellen; wobei jede Verbindungsleitung ($BL_{1a}$, $BL_{1b}$ $BL_{2a}$ $BL_{2b}$) mit einer benachbarten Verbindungsleitung ($BL_{1a}$, $BL_{1b}$ $BL_{2a}$ $BL_{2b}$) über einen Schalter (i1) verbunden ist.

12. Berechnungsschaltkreis im Speicher (10) nach Anspruch 11, wobei die Steuereinrichtung konfiguriert ist, um den Transfer von gespeicherten Daten von einer Startspeicherzelle ($CM_1$) zu einer Zielspeicherzelle ($CM_2$) die zu einer anderen Ebene als die der Startspeicherzelle gehört und mit einer zu der Startspeicherzelle benachbarten Verbindungsleitung verbunden ist, durchzuführen;

der Transfer wird durchgeführt, indem die folgenden Schritte ausgeführt werden:

i'- Initialisieren der Zielzelle (CM2) auf einen hohen resistiven Zustand;
ii'- Schließen des Schalters i1;
iii'- Gleichzeitiges Durchführen der folgenden Schritte:

a. Anlegen einer positiven ersten Übertragungsspannung an den ersten Ein-/Ausgabeanschluss ($SL_{1a}$) der Startspeicherzelle ($CM_1$) ;
b. Verbinden des ersten Ein-/Ausgabeanschlusses ($SL_{2b}$) der Zielspeicherzelle mit elektrischer Masse;
c. Anlegen einer positiven zweiten Übertragungsspannung an den ersten Ein-/Ausgabeanschluss ($SL_{1b}$) der Speicherzelle ($CM_{par\_in}$) die zu derselben Ebene der Startspeicherzelle gehört und mit derselben Verbindungsleitung der Zielspeicherzelle verbunden ist;

d. Anlegen der positiven zweiten Übertragungsspannung an den ersten Ein-/Ausgabeanschluss ($SL_{2a}$) der Speicherzelle ($CM_{par\_out}$) die zu derselben Ebene der Zielspeicherzelle gehört und mit derselben Bit-Leitung der Startspeicherzelle verbunden ist;

wobei die Amplitude der zweiten Übertragungsspannung kleiner oder gleich der Hälfte der ersten Übertragungsspannung ist.

13. Berechnungsschaltkreis im Speicher (10) nach einem der Ansprüche 1 bis 5, wobei für jede elementare Gruppe von Speicherzellen die Verbindungsleitung ($SL_{1a}$) die ersten Ein-/Ausgabeanschlüsse (SL) der Speicherzellen der besagten elementaren Gruppe miteinander verbindet.


**Claims**

1. In-memory computing circuit (10) comprising a plurality of memory planes ($P_i$) of the order i ranging from 1 to N, with N being a natural number greater than 1, each plane forming a two-dimensional matrix of non-volatile resistive and programmable memory cells, each memory cell having a selection node (WL), a first input/output node (SL) and a second input/output node (BL); the matrix comprising M rows ($L_j$) of the order j ranging from 1 to M and K columns ($C_k$) of the order k ranging from 1 to K, with M and K being two natural numbers not equal to zero; the calculation circuit (10) comprising:

   - control means which are configured to control the nodes of the memory cells in order to carry out storage and memory calculation operations carried out by the calculation circuit;
   - at least one elementary group of memory cells comprising:

      - a first memory cell ($CM_A$) which belongs to any one of the memory planes ($P_{in1}$) and which is intended to store a first input data item (A);
      - a second memory cell ($CM_B$) which belongs to any one of the memory planes ($P_{in1}$) and which is intended to store a second input data item (B);
      - a third memory cell ($CM_{OR}$, $CM_{AND}$) which belongs to a memory plane ($P_{OR1}$) which differs from that of the first and second memory cells ($CM_A$ $CM_b$); the third memory cell being intended to store the result of a first logic operation which has as operands the first and the second input data items;

      the first, second and third memory cells ($CM_A$, $CM_B$ $CM_{OR}$) belonging to columns ($C_k$) of the same order k in their respective matrices;
      the first, second and third memory cells ($CM_A$, $CM_B$, $CM_{OR}$) being interconnected by a common interconnection line ($BL_{1a}$, $SL_{1a}$); the common interconnection line connecting the first input/output nodes (SL) of the memory cells of the elementary group or the second input/output nodes (BL) of the memory cells of the elementary group to each other;
      for each memory plane ($P_i$):

      the selection nodes (WL) of the memory cells belonging to the same row ($L_j$) are interconnected by a selection line ($WL_{ij}$);
      the first input/output nodes (SL) of the memory cells belonging to the same column ($C_k$) are interconnected;
      the second input/output nodes (BL) of the memory cells belonging to the same column ($C_k$) are interconnected.

2. In-memory computing circuit (10) according to claim 1, wherein each memory cell ($CM_A$, $CM_B$, $CM_{OR}$) comprises:

   - a resistive programmable storage structure having:

      - an upper electrode (EL1) which is connected to the second input/output node (BL) of the memory cell ($CM_A$, $CM_B$, $CM_{OR}$);
      - and a lower electrode (EL2);

   - a selection transistor (T1) which has a gate which is connected to the selection node (WL) of the memory cell and which connects the lower electrode (EL2) to the first input/output node (SL) of the memory cell ($CM_A$, $CM_B$, $CM_{OR}$).

3. In-memory computing circuit (10) according to claim 2, wherein each column ($C_k$) of memory cells (CM) comprises:

- a stack of a plurality of selection transistors (T1) in a first direction ($\Delta$)

each selection transistor, in particular of the gate-all-around type comprising a conduction channel (CC) which is perpendicular to the first direction ($\Delta$), is made of a semiconductor material and has two ends; the first end of the channel corresponding to the source of the selection transistor and the second end corresponding to the drain of the transistor;

- a first metal pillar ($SL_{1a}$) in the first direction ($\Delta$) connecting the sources of the different selection transistors;
- a dielectric layer (C'2) which is parallel with the first direction ($\Delta$) and which laterally covers the drains of the selection transistors;
- at least one metal layer (C'3) parallel with the first direction being deposited on the dielectric layer;
- a second metal pillar ($BL_{1a}$) in the first direction ($\Delta$) having a lateral contact with the at least one metal layer;

for each selection transistor, the assembly formed by the drain, the dielectric layer (C'2) and the metal layer (C'3) constitutes a resistive storage structure (S1).

4. In-memory computing circuit (10) according to any one of the preceding claims, such that for each memory plane ($P_{in1}$, $P_{OR1}$):

the first input/output nodes (SL) of the memory cells belonging to the columns ($C_k$) of uneven rows are interconnected, forming a first source row ($SL_{1a}$);
the first input nodes (SL) of the memory cells belonging to the columns ($C_k$) of even rows are interconnected, forming a second source row ($SL_{1b}$);
the first source row and the second source row being separate.

5. In-memory computing circuit (10) according to any one of claims 1 to 4, in which the elementary group of memory cells further comprises a fourth memory cell ($CM_{XNOR}$) which belongs to a memory plane which is different from that of the first, second and third memory cells ($CM_A$ $CM_b$, $CM_{OR}$); the fourth memory cell being intended to store the result of a second logic operation which has as operands the first and the second input data and which uses the result of the first logic operation which is stored in the third memory cell ($CM_{OR}$) ;
the fourth memory cell ($CM_{XNOR}$) being connected to the first, second and third memory cells ($CM_A$, $CM_B$, $CM_{OR}$) via the common interconnection line ($BL_{1a}$, $SL_{1a}$).

6. In-memory computing circuit (10) according to any one of claims 1 to 5, wherein, for each elementary group of memory cells, the interconnection line ($BL_{1a}$) connects the second input/output nodes (BL) of the memory cells of the elementary group to each other.

7. In-memory computing circuit (10) according to any one of claims 1 to 6, wherein the control means are configured to carry out the following steps in order to carry out the logic function OR:

i- initializing the third cell at a high resistive state;
ii- selecting the first and third memory cell ($CM_A$, $CM_{OR}$) by placing their selection transistors (T1) into the on state;
iii- applying a first positive reading voltage to the first input/output node ($SL_{1a}$) of the first memory cell and simultaneously connecting the first input/output node ($SL_{2a}$) of the third memory cell to the electrical earth;
iv- selecting the second and third memory cell ($CM_B$, $CM_{OR}$) by placing their selection transistors into the on state (T1);
v- applying the first positive reading voltage to the first input/output node ($SL_{1a}$) of the first memory cell and simultaneously connecting the first input/output node ($SL_{2a}$) of the third memory cell to the electrical earth;

each memory cell having:

a first voltage threshold ($V_{set}$) to change from a high resistive state to a low resistive state; and a second voltage threshold ($V_{reset}$) to change from a low resistive state to a high resistive state which is greater than the first voltage threshold ($V_{set}$);
the first reading voltage being positive with an amplitude which is greater than or equal to the first passage threshold and which is strictly less than the second passage threshold.

8. In-memory computing circuit (10) according to any one of claims 1 to 6, wherein the control means are configured to carry out the following steps in order to carry out the exclusive logic function NO-OR (XNOR):

i- initializing the fourth cell at a low resistive state;
ii- selecting the first, third and fourth memory cell ($CM_A$, $CM_{OR}$, $CM_{XNOR}$) by placing their transistors into the on state;
iii- simultaneously carrying out:

a- the application of a second positive reading voltage ($VSL_{1a}$) to the first input/output node ($SL_{1a}$) of the first memory cell ($CM_A$) ;
b- the application of a third negative reading voltage ($VSL_{2a}$) to the first input/output node ($SL_{2a}$) of the third memory cell ($CM_{OR}$) ;
c- and the application of a fourth positive reading voltage ($VSL_{3a}$) to the first input/output node ($SL_{3a}$) of the fourth memory cell ($CM_{XNOR}$) ;

iv- selecting the second, third and fourth memory cell ($CM_B$, $CM_{OR}$, $CM_{XNOR}$) by placing their selection transistors (T1) into the on state;
v- simultaneously carrying out:

a- the application of the second positive reading voltage ($VSL_{1a}$) to the first input/output node ($SL_{1a}$) of the second memory cell ($CM_B$);
b- the application of the third negative reading voltage ($VSL_{2a}$) to the first input/output node ($SL_{2a}$) of the third memory cell ($CM_{OR}$);
c- and the application of a fourth positive reading voltage ($VSL_{3a}$) to the first input/output node ($SL_{3a}$) of the fourth memory cell ($CM_{XNOR}$);

the absolute value of the third reading voltage ($VSL_{2a}$) being substantially equal to the absolute value of the second reading voltage ($VSL_{1a}$);
the sum of the absolute value of the fourth reading voltage ($VSL_{3a}$) and the third reading voltage ($VSL_{2a}$) being greater than the second passage threshold ($V_{reset}$).

9. In-memory computing circuit (10) according to any one of claims 1 to 6, wherein the control means are configured to carry out the following steps in order to carry out the logic function ET:

i- initializing the third cell at a high resistive state;
ii- selecting the first and third memory cell ($CM_A$, $CM_{AND}$) by placing their selection transistors (T1) into the on state;
iii- applying a first positive reading voltage ($VSL_{1a}$) to the first input/output node ($SL_{1a}$) of the first memory cell and applying a second positive reading voltage ($VSL_{2a}$) to the third input/output node ($SL_{2a}$) of the third memory cell ($CM_{AND}$);
iv- selecting the second and third memory cell ($CM_B$, $CM_{AND}$) by placing their selection transistors (T1) into the on state;
v- applying the first positive reading voltage ($VSL_{1a}$) to the first input/output node ($SL_{1a}$) of the first memory cell and applying the second positive reading voltage ($VSL_{2a}$) to the third input/output node ($SL_{2a}$) of the third memory cell ($CM_{AND}$);

each memory cell having:

a first voltage threshold ($V_{set}$) to change from a high resistive state to a low resistive state; and a second voltage threshold ($V_{reset}$) to change from a low resistive state to a high resistive state which is greater than the first voltage threshold ($V_{set}$);
the first reading voltage ($VSL_{1a}$) having an amplitude which is strictly less than the second voltage threshold ($V_{reset}$); the second reading voltage ($VSL_{2a}$) having an amplitude which is strictly greater than the second voltage threshold ($V_{reset}$).

10. In-memory computing circuit (10) according to any one of the preceding claims, comprising for each interconnection line ($BL_{1a}$, $BL_{1b}$ $BL_{2a}$ $BL_{2b}$) a control transistor ($T_{reg}$); each control transistor ($T_{reg}$) having a gate which receives a control signal ($VWL_{BL}$) and which connects the associated interconnection line to the electrical earth or to a supply voltage (VDD) of the calculation circuit in order to produce a variable impedance.

11. In-memory computing circuit (10) according to any one of the preceding claims, comprising a plurality of elementary groups of memory cells; each interconnection line ($BL_{1a}$, $BL_{1b}$ $BL_{2a}$ $BL_{2b}$) being connected to an adjacent interconnection line ($BL_{1a}$, $BL_{1b}$ $BL_{2a}$ $BL_{2b}$) via a switch (i1).

12. In-memory computing circuit (10) according to claim 11, wherein the control means are configured to carry out the transfer of a stored data item from a departure memory cell ($CM_1$) to an arrival memory cell ($CM_2$) which belongs to a plane which is different from that of the departure memory cell and which is connected to an interconnection line adjacent to that of the departure memory cell;

the transfer is carried out by executing the following steps:

i'- initializing the arrival cell ($CM_2$) at a high resistive state;
ii'- placing the switch i1 into the on state
iii'- simultaneously carrying out:

a. the application of a first positive transfer voltage to the first input/output node ($SL_{1a}$) of the departure memory cell $CM_1$) ;
b. the connection of the first input/output node ($SL_{2b}$) of the arrival memory cell to the electrical earth;
c. the application of a second positive transfer voltage to the first input/output node ($SL_{1b}$) of the memory cell ($CM_{par\_in}$) belonging to the same plane of the departure memory cell and being connected to the same interconnection line of the arrival memory cell;
d. the application of the second positive transfer voltage to the first input/output node ($SL_{2a}$) of the memory cell ($CM_{par\_out}$) belonging to the same plane of the arrival memory cell and being connected to the same line of bits of the departure memory cell;

the amplitude of the second transfer voltage being less than or equal to half of the first transfer voltage.

13. In-memory computing circuit (10) according to any one of claims 1 to 5, wherein, for each elementary group of memory cells, the interconnection line ($SL_{1a}$) connects the first input/output nodes (SL) of the memory cells of the elementary group to each other.

FIG.1a

FIG.1b

FIG.2a

```
                 ┌─────────────────────────┐
   100 ──┐       │  Initialiser CM_OR à un état │
         └───────│       résistif haut      │
                 └─────────────────────────┘
                              │
                              ▼
   ┌ ─ ─ ─ ─ ─ ─ ─ ─ ─ ─ ─ ─ ─ ─ ─ ─ ─ ─ ─ ┐
   │             ┌─────────────────────────┐
   200 ──┐       │  Sélectionner CM_OR et CM_A │
   │     └───────│                         │
                 └─────────────────────────┘
   201 ──┐              │
   │     └──────        ▼
                 ┌─────────────────────────┐
   │             │ Appliquer une tension positive sur │
   202 ──┐       │  SL_1a et relier SL_2a à la masse  │
   │     └───────│                         │
                 └─────────────────────────┘
   └ ─ ─ ─ ─ ─ ─ ─ ─ ─ ─ ─ ─ ─ ─ ─ ─ ─ ─ ─ ┘
                              │
   ┌ ─ ─ ─ ─ ─ ─ ─ ─ ─ ─ ─ ─ ▼ ─ ─ ─ ─ ─ ─ ┐
   │             ┌─────────────────────────┐
   300 ──┐       │  Sélectionner CM_OR et CM_B │
   │     └───────│                         │
                 └─────────────────────────┘
   301 ──┤              │
   │                    ▼
                 ┌─────────────────────────┐
   │             │ Appliquer une tension positive sur │
   302 ──┐       │  SL_1a et relier SL_2a à la masse  │
   │     └───────│                         │
                 └─────────────────────────┘
   └ ─ ─ ─ ─ ─ ─ ─ ─ ─ ─ ─ ─ ─ ─ ─ ─ ─ ─ ─ ┘
                              │
                              ▼
```

| A | B | OR |
|---|---|-----|
| 0 | 0 | 0 |
| 1 | 0 | $0 \rightarrow 1$ |
| 0 | 1 | $0 \rightarrow 1$ |
| 1 | 1 | $0 \rightarrow 1$ |

# FIG.2b

FIG.3a

$$\vdots$$

| 400 | Initialiser $CM_{OR}$ à un état résistif bas |
|---|---|

| 500 | | |
|---|---|---|
| 501 | Sélectionner $CM_{XNOR}$, $CM_{OR}$ et $CM_A$ | |
| 502 | Appliquer une tension $VSL_{1a} > 0$ sur $SL_{1a}$ ; Appliquer une tension $VSL_{2a} < 0$ sur $SL_{2a}$ Appliquer une tension $VSL_{3a} > 0$ sur $SL_{3a}$ | |

| 600 | | |
|---|---|---|
| 601 | Sélectionner $CM_{XNOR}$, $CM_{OR}$ et $CM_B$ | |
| 602 | Appliquer une tension $VSL_{1a} > 0$ sur $SL_{1a}$ ; Appliquer une tension $VSL_{2a} < 0$ sur $SL_{2a}$ Appliquer une tension $VSL_{3a} > 0$ sur $SL_{3a}$ | |

| A | B | OR | XNOR |
|---|---|---|---|
| 0 | 0 | 0 | 1 |
| 1 | 0 | $0 \rightarrow 1$ | $1 \rightarrow 0$ |
| 0 | 1 | $0 \rightarrow 1$ | $1 \rightarrow 0$ |
| 1 | 1 | $0 \rightarrow 1$ | 1 |

## FIG.3b

100' — Initialiser $CM_{AND}$ à un état résistif bas

200' —

201' — Sélectionner $CM_{AND}$ et $CM_A$

202' — Appliquer une tension $VSL_{2a} > 0$ sur $SL_{2a}$ ; Appliquer une tension $0 < VSL_{1a} < VSL_{2a}$ sur $SL_{1a}$

300' —

301' — Sélectionner $CM_{AND}$ et $CM_B$

302' — Appliquer une tension $VSL_{2a} > 0$ sur $SL_{2a}$ ; Appliquer une tension $0 < VSL_{1a} < VSL_{2a}$ sur $SL_{1a}$

| A | B | AND |
|---|---|---|
| 0 | 0 | 1→0 |
| 1 | 0 | 1→0 |
| 0 | 1 | 1→0 |
| 1 | 1 | 1 |

FIG.4

FIG.5a

FIG.5b

FIG.5c

FIG.6a

FIG.6b

**i'** — Initialiser $CM_2$ à un état résistif haut

**ii'** — Mettre l'interrupteur i1 à l'état passant

**iii'** —
L'application d'une tension de transfert $VSL_{1a} > 0$ sur $SL_{1a}$

La connexion de $SL_{2b}$ à la masse électrique

L'application d'une tension de transfert $0 < VSL_{1b} > VSL_{1a}$ sur $SL_{1b}$

L'application d'une tension de transfert $0 < VSL_{2a} > VSL_{1a}$ sur $SL_{2a}$

## FIG.6c

A XNOR B

A OR B

B

A

Z  X  Y

1a

AB[0]  AB[1]  AB[2]  AB[3]  AB[4]  AB[5]

(A+B)[0](A+B)[1](A+B)[2](A+B)[3](A+B)[4](A+B)[5]

| | | | | | |
|---|---|---|---|---|---|
| D[0] | D[1] | D[2] | D[3] | D[4] | D[5] |
| C[0] | C[1] | C[2] | C[3] | C[4] | C[5] |
| B[0] | B[1] | B[2] | B[3] | B[4] | B[5] |
| A[0] | A[1] | A[2] | A[3] | A[4] | A[5] |

1b

| | | | | | | |
|---|---|---|---|---|---|---|
| ABD | 1 | 0 | 1 | 0 | 0 | 0 |
| AB | 1 | 0 | 0 | 1 | 0 | 0 |
| AB+D | 1 | 1 | 0 | 1 | 1 | 1 |
| D | 1 | 1 | 0 | 0 | 1 | 1 |
| | 0 | 1 | 0 | 1 | 0 | 1 |
| | 0 | 1 | 0 | 1 | 1 | 0 |
| | 0 | 0 | 1 | 1 | 0 | 1 |

4 itérations pour ABD,
BDC, DCA et CAD

| | | | | | | |
|---|---|---|---|---|---|---|
| ABD | 1 | 0 | 1 | 0 | 0 | 0 |
| BDC | 1 | 1 | 0 | 0 | 0 | 0 |
| DCA | 1 | 0 | 1 | 0 | 0 | 0 |
| CAD | 0 | 0 | 1 | 1 | 1 | 0 |

ABDCA

| 1 | 0 | 1 | 0 | 0 | 0 |
|---|---|---|---|---|---|

# FIG.7

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **A. SEBASTIAN**. Memory devices and applications for in-memory computing. *Nature nanotechnology*, 2020
- **H.LI et al.** Four-Layer 3D Vertical RRAM Integrated with FinFET as a Versatile Computing Unit for Brain-Inspired Cognitive Information Processing. *Symposium on VLSI Technology Digest of Technical Papers*, 2016
- Innovative 3D Technology of a nonvolatile memory cell. *In-Memory-Computing, Théophile Dubreuil*